(19) Europäisches Patentamt / European Patent Office / Office européen des brevets

(11) **EP 2 605 354 B1**

(12) **EUROPÄISCHE PATENTSCHRIFT**

(45) Veröffentlichungstag und Bekanntmachung des Hinweises auf die Patenterteilung:
**02.05.2018   Patentblatt 2018/18**

(51) Int Cl.:
***H02H 7/26*** (2006.01)          ***G01R 31/08*** (2006.01)

(21) Anmeldenummer: **13075022.7**

(22) Anmeldetag: **16.12.2009**

(54) **Schutz von Parallelleitungen eines elektrischen Energieversorgungsnetzes**

Protection for parallel lines in an electrical energy supply network

Protection de lignes parallèles d'un réseau d'alimentation en énergie électrique

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**19.06.2013   Patentblatt 2013/25**

(62) Dokumentnummer(n) der früheren Anmeldung(en) nach Art. 76 EPÜ:
**09807539.3 / 2 514 059**

(73) Patentinhaber: **Siemens Aktiengesellschaft 80333 München (DE)**

(72) Erfinder:
• **Blumschein, Jörg**
  **14165 Berlin (DE)**
• **Kereit, Matthias**
  **12159 Berlin (DE)**
• **Sezi, Tevfik**
  **91052 Erlangen (DE)**
• **Steynberg, Gustav**
  **91338 Igensdorf (DE)**
• **Yelgin, Yilmaz**
  **13589 Berlin (DE)**

(56) Entgegenhaltungen:
**EP-A2- 1 313 194          WO-A1-00/31849
WO-A1-99/40662          WO-A2-2007/025257
US-A1- 2009 088 989**

**Beschreibung**

Die Erfindung betrifft ein Verfahren zum Überwachen eines mehrphasigen elektrischen Energieversorgungsnetzes, wobei ein erstes Schutzgerät mit einer ersten Leitung des Energieversorgungsnetzes zum Erfassen von den Betriebszustand der ersten Leitung charakterisierenden Messwerten in Verbindung steht, wobei das erste Schutzgerät über eine Kommunikationsverbindung mit einem benachbart angeordneten zweiten Schutzgerät verbunden ist, und wobei das zweite Schutzgerät mit einer parallel zu der ersten Leitung verlaufenden zweiten Leitung des Energieversorgungsnetzes zum Erfassen von den Betriebszustand der zweiten Leitung charakterisierenden Messwerten in Verbindung steht, die beiden Schutzgeräte die von ihnen bezüglich ihrer jeweiligen Leitung erfassten Messwerte und/oder von diesen Messwerten abgeleitete Signale an das jeweils andere Schutzgerät übertragen, jedes Schutzgerät zur Ausführung einer Schutzfunktion, insbesondere einer Distanzschutzfunktion, für seine jeweilige Leitung unter Ausführung eines Haupt-Schutzalgorithmus eingerichtet ist, das erste Schutzgerät zur Ausführung seines Haupt-Schutzalgorithmus die an der ersten Leitung erfassten Messwerte sowie die von dem zweiten Schutzgerät empfangenen Messwerte und/oder Signale heranzieht, und das zweite Schutzgerät zur Ausführung seines Haupt-Schutzalgorithmus die an der zweiten Leitung erfassten Messwerte sowie die von dem ersten Schutzgerät empfangenen Messwerte und/oder Signale heranzieht. Die Erfindung betrifft außerdem ein Schutzsystem für ein elektrisches Energieversorgungsnetz sowie ein elektrisches Schutzgerät zur Überwachung einer Leitung eines elektrischen Energieversorgungsnetzes.

Ein solches Verfahren, Schutzsystem und Schutzgerät ist beispielsweise aus der WO 00/31849 bekannt.

Zur Überwachung von Leitungen elektrischer Energieversorgungsnetze werden sogenannte Schutzgeräte eingesetzt, um unzulässige Betriebszustände der jeweils überwachten Leitung, die beispielsweise durch Kurzschlüsse oder Erdkurzschlüsse hervorgerufen sein können, zu erkennen und automatisch abzuschalten. Hierzu nimmt das elektrische Schutzgerät üblicherweise Messwerte auf, beispielsweise Strom- und/oder Spannungsmesswerte, die den Betriebszustand der Leitung charakterisieren. Zur Ausführung seiner Schutzfunktion, wertet das Schutzgerät daraufhin die Messwerte unter Ausführung eines sogenannten Schutzalgorithmus, also einer Berechnungs- und/oder logischen Verknüpfungsvorschrift zur Auswertung der aufgenommenen Messwerte, aus und erzeugt in Abhängigkeit vom Ergebnis der Auswertung gegebenenfalls ein Auslösesignal, das einen mit dem Schutzgerät in Verbindung stehenden Leistungsschalter zum Öffnen seiner Schaltkontakte veranlasst, um die fehlerbehaftete Leitung vom übrigen Energieversorgungsnetz abzutrennen.

Ein häufig zur Überwachung von Leitungen elektrischer Energieversorgungsnetze eingesetzter Schutzalgorithmus arbeitet nach dem sogenannten Distanzschutzverfahren, bei dem aus Strom- und Spannungsmesswerten in einer komplexen Zahlenebene liegende Impedanzwerte berechnet werden und überprüft wird, ob die Impedanzwerte innerhalb eines - auch als Auslösepolygon bezeichneten - vorgegebenen Auslösebereiches liegen. Sofern die Impedanzwerte innerhalb dieses vorgegebenen Auslösebereiches liegen, stellt das Distanzschutzgerät einen unzulässigen Betriebszustand an der von ihm überwachten Leitung des elektrischen Energieversorgungsnetzes fest und sendet ein Auslösesignal an einen oder mehrere die Leitung begrenzende Leistungsschalter, um die fehlerhafte Leitung vom restlichen Energieversorgungsnetz zu trennen.

In den letzten Jahren haben sich elektrische Schutzgeräte von ausschließlich eigenständig arbeitenden Überwachungsgeräten immer stärker zu sogenannten intelligenten elektronischen Geräten (Intelligent Electronic Devices = IEDs) entwickelt, die mit anderen Schutzgeräten in einem gemeinsamen Kommunikationsnetzwerk datentechnisch vernetzt sind, um eine weitere Verbesserung der Leistungsfähigkeit und der Zuverlässigkeit bei der Überwachung des Energieversorgungsnetzes zu erreichen. So ist beispielsweise aus der internationalen Patentanmeldung WO 2009/012800 A1 bekannt, Schutzgeräte über eine Kommunikationsverbindung mit anderen Schutzgeräten zu verbinden und über diese Kommunikationsverbindung Messwerte, die zur Durchführung einer Reserveschutzfunktion benötigt werden, auszutauschen. Die bekannte internationale Patenanmeldung beschreibt hierzu ein Differentialschutzsystem mit einer Reserveschutzfunktion, die es den beteiligten Schutzgeräten ermöglicht, auch beim Ausfall eines für eine primäre Schutzfunktion zuständigen Schutzgerätes aufgrund der übertragenen Messwerte mittels einer Reserveschutzfunktion eine Entscheidung zu treffen, ob ein unzulässiger Betriebszustand in einem Abschnitt eines elektrischen Energieversorgungsnetzes vorliegt, und den Abschnitt im Fehlerfall abzuschalten.

Aufgrund der in den letzten Jahren kontinuierlich gewachsenen Leistungsaufnahme der an ein Energieversorgungsnetz angeschlossenen elektrischen Endverbraucher und der damit einhergehenden stetig ansteigenden Belastung der Versorgungsleitungen des Energieversorgungsnetzes sind die Betreiber von Energieversorgungsnetzen weitgehend dazu übergegangen, sogenannte "Parallelleitungen", also mehrere parallel zueinander entlang einer Energieübertragungsstrecke angeordnete Energieversorgungsleitungen, zu verlegen. Parallelleitungen können beispielsweise durch Verlegen zusätzlicher Übertragungsleitungen entlang bereits bestehender Freileitungsmasten oder durch paralleles Verlegen mehrerer Erdkabel erreicht werden. Hierdurch kann bei verhältnismäßig geringem installations auf wand - z.B. durch Mehrfachnutzung bestehender Freileitungsmasten - auf nahezu demselben Raum eine größere Menge elektrischer Energie transportiert werden. Neben der Steigerung der Übertragungskapazität erhöht sich bei Installation von Parallelleitungen auch die Redundanz des Versorgungssystems, da bei einem Ausfall einer der Parallelleitungen die elektrische Energie für einen begrenzten Zeitraum über die andere Parallelleitung übertragen werden kann. Auf diese Weise können Beeinträchtigungen der Versorgungssicherheit für die Endverbraucher möglichst gering gehalten werden.

Der Erfindung liegt die Aufgabe zugrunde, Zuverlässigkeit und Selektivität von Entscheidungen über Betriebszustände von Parallelleitungen - also parallel zueinander verlaufenden Leitungen eines elektrischen Energieversorgungsnetzes - zu erhöhen.

Zur Lösung dieser Aufgabe wird ein Verfahren der eingangs genannten Art vorgeschlagen, bei dem die Schutzfunktion eine Distanzschutzfunktion umfasst, wobei die Schutzgeräte zur Durchführung der Distanzschutzfunktion mittels des Haupt-Schutzalgorithmus aus den an ihrer jeweiligen Leitung erfassten Messwerten komplexe Impedanzwerte berechnen und ein Fehlersignal erzeugen, wenn die Impedanzwerte innerhalb eines Auslösegebietes liegen; zwischen den benachbarten Schutzgeräten an den einzelnen Phasen der jeweils eigenen Leitung erfasste Messwerte über die Kommunikationsverbindung ausgetauscht werden; die Schutzfunktion unter Berücksichtigung der eigenen Messwerte und der Messwerte vom jeweils anderen Schutzgerät eine Überprüfung durchführt, ob gleichzeitig auf beiden Leitungen ein Erdkurzschluss vorliegt, indem die Strommesswerte der einzelnen Phasen jeweils untereinander oder mit bestimmten Schwellenwerten verglichen werden, um einzelne Phasen beider Leitungen zu erkennen, in denen vergleichsweise hohe Ströme fließen, und ein gleichzeitig auf beiden Leitungen vorliegender Erdkurzschluss erkannt wird, wenn für die erkannten Phasen zusätzlich die komplexen Impedanzwerte in dem Auslösegebiet liegen, und bei positivem Ergebnis der Überprüfung die Schutzfunktion eine Auslösung der entsprechenden Leistungsschalter nur bezüglich der von dem Fehler tatsächlich betroffenen Phasen der beiden Leitungen veranlasst.

Die Schutzgeräte führen zur Überwachung ihrer jeweiligen Leitungen eine Schutzfunktion durch, zu deren Ausführung der Haupt-Schutzalgorithmus abgearbeitet wird. Bei der Schutzfunktion kann es sich bevorzugt um eine Distanzschutzfunktion handeln. Der Haupt-Schutzalgorithmus kann dabei einen oder mehrere Teile der Schutzfunktion betreffen, auch kann die Schutzfunktion durch Ausführung mehrerer Haupt-Schutzalgorithmen verwirklicht werden; Beispiele dafür werden an späterer Stelle genauer erläutert. Für die Durchführung der Erfindung ist es ferner unkritisch, ob in den Schutzgeräten neben der genannten Schutzfunktion, z.B. der Distanzschutzfunktion, noch weitere Schutzfunktionen bereitgestellt werden, z.B. eine Differentialschutzfunktion oder eine Überstromschutzfunktion.

Der Erfindung liegt die Erkenntnis zugrunde, dass bei parallelen Leitungen eines elektrischen Energieversorgungsnetzes zwischen den Parallelleitungen eine starke elektrische und/oder elektromagnetische Kopplung besteht, die bei einer zuverlässigen Entscheidung über den auf der jeweiligen Parallelleitung vorliegenden Betriebszustand berücksichtigt werden sollte. Die erfindungsgemäße Lösung sieht daher vor, dass zwischen benachbarten Schutzgeräten, von denen ein erstes Schutzgerät einer ersten Leitung zugeordnet ist und ein zweites Schutzgerät einer parallel zu der ersten Leitung verlaufenden zweiten Leitung zugeordnet ist, eine Kommunikationsverbindung besteht, über die diejenigen Messwerte, die jedes Schutzgerät für seine Leitung erfasst hat, und/oder von diesen Messwerten abgeleitete Signale, die z.B. einen Betriebszustand der jeweiligen Leitung angeben oder einen Steuerbefehl für das jeweils andere Schutzgerät umfassen, zur jeweils anderen Leitung übertragen werden.

Erfindungsgemäß werden zwischen den benachbarten Schutzgeräten hinsichtlich der einzelnen Phasen der jeweils eigenen Leitung erfasste Messwerte über die Kommunikationsverbindung ausgetauscht. Die Schutzfunktion des jeweiligen Schutzgeräts führt unter Berücksichtigung der eigenen Messwerte und der Messwerte vom jeweils anderen Schutzgerät eine Überprüfung durch, ob auf beiden Leitungen (nahezu) gleichzeitig ein Erdkurzschluss vorliegt. Bei positivem Ergebnis der Überprüfung veranlasst die Schutzfunktion eine Auslösung der entsprechenden Leistungsschalter nur bezüglich der von dem Fehler tatsächlich betroffenen Phasen der beiden Leitungen.

Hierdurch können selektiv nahezu gleichzeitig auf beiden Leitungen stattfindende Erdkurzschlüsse, d.h. sich innerhalb eines Zeitraums von einigen 100 ms überlappende Erdkurzschlüsse, sogenannte "Cross-Country-Faults" abgeschaltet werden.

Als benachbarte Schutzgeräte werden in diesem Zusammenhang solche Schutzgeräte angesehen, die an demselben Ende der Parallelleitungen angeordnet sind. Eines der benachbarten Schutzgeräte ist hierbei der ersten, das andere der zweiten Parallelleitung zugeordnet. Bei mehr als zwei Parallelleitungen sind an jedem Ende entsprechend mehr als zwei benachbarte Schutzgeräte vorhanden, die Erfindung kann entsprechend auch auf mehr als zwei Parallelleitungen angewendet werden.

Ferner können die jeweiligen Schutzgeräte einzelne abgeschlossene Geräte sein oder aber auch durch Gerätegruppen einzelner Geräte gebildet sein (beispielsweise einem Distanzschutzgerät, einer Schaltersteuerung und/oder einer Merging Unit), die gemeinsam eine Schutzfunktion für die jeweilige Leitung ausführen. Der Einfachheit halber wird jedoch in den folgenden Ausführungen jeweils von einem "Schutzgerät" gesprochen.

Durch Berücksichtigung der an der jeweils eigenen Leitung erfassten Messwerte einerseits und der vom Schutzgerät der jeweils anderen Leitung empfangenen Messwerte und/oder davon abgeleiteten Signale andererseits zur Durchführung einer Schutzfunktion für die eigene (also die von dem jeweiligen Schutzgerät überwachte) Leitung kann eine deutlich genauere - und damit selektivere und zuverlässigere - Entscheidung über den Betriebszustand der Leitung getroffen werden. Da die Messwerte über eine Kommunikationsverbindung zwischen den Schutzgeräten übertragen werden, müssen zwischen den Schutzgeräten keine direkten elektrischen Verbindungsleitungen zur Übertragung der von Strom- und/oder Spannungswandlern an der jeweiligen Leitung abgegebenen und vergleichsweise hohen Sekundärströme oder Sekundärspannungen verlegt werden. So kann eine Information über die Messwerte und/oder Signale der jeweils anderen Leitung sehr sicher zwischen den Schutzgeräten ausgetauscht werden, ohne Gefahr zu laufen, bei versehentlicher Beschädigung einer direkten elektrischen Verbindungsleitung einen Schaden durch hohe Sekundärströme oder -spannungen hervorzurufen.

Eine vorteilhafte Weiterbildung des erfindungsgemäßen Verfahrens sieht vor, dass die erste und die zweite Leitung jeweils dreiphasige Leitungen eines dreiphasigen Energieversorgungsnetzes sind, beide Schutzgeräte jeweils für jede Phase gesondert die Messwerte der jeweiligen Leitung erfassen, und über die Kommunikationsverbindung für jede Phase die entsprechenden Messwerte und/oder von diesen Messwerten abgeleitete Signale übertragen werden.

Auf diese Weise kann die Überwachung der parallelen Leitungen phasenselektiv, d. h. für jede der drei Phasen des Energieversorgungsnetzes getrennt, durchgeführt werden, so dass beispielsweise bei einem Fehler, von dem nur eine Phase betroffen ist, selektiv nur eine Abschaltung der fehlerbehafteten Phase erfolgt.

Eine weitere vorteilhafte Ausbildung des erfindungsgemäßen Verfahrens sieht vor, dass beide Schutzgeräte eine Zeitstempeleinrichtung aufweisen, mit der den an der jeweiligen Leitung erfassten Messwerten jeweils ein den Zeitpunkt ihrer Erfassung angebender Zeitstempel zugeordnet wird, und gemeinsam mit den über die Kommunikationsverbindung übertragenen Messwerten jeweils die zugehörigen Zeitstempel übermittelt werden.

Auf diese Weise können die erfassten Messwerte mit einem ihren genauen Erfassungszeitpunkt angebenden Zeitstempel versehen werden, so dass ein Vergleich und eine Verarbeitung der zu einem bestimmten Zeitpunkt von unterschiedlichen Schutzgeräten aufgenommenen Messwerte einfach möglich ist.

Eine weitere vorteilhafte Ausbildung des erfindungsgemäßen Verfahrens sieht ferner vor, dass beide Schutzgeräte jeweils eine Kommunikationsüberwachungseinrichtung aufweisen, die die Funktionstüchtigkeit der Kommunikationsverbindung überwacht und ein Ausfallsignal abgibt, wenn die Funktionstüchtigkeit der Kommunikationsverbindung nicht gewährleistet ist, und von den Schutzgeräten bei vorliegendem Ausfallsignal zur Ausführung der Schutzfunktion für ihre jeweilige Leitung ein von dem Haupt-Schutzalgorithmus verschiedener Ersatz-Schutzalgorithmus verwendet wird, der nur die an der jeweils eigenen Leitung erfassten Messwerte, nicht aber die von dem jeweils anderen Schutzgerät empfangenen Messwerte und/oder Signale heranzieht.

Hierdurch kann erreicht werden, dass im Falle fehlender Funktionstüchtigkeit der Kommunikationsverbindung zwischen den beiden Schutzgeräten, beispielsweise aufgrund einer mechanischen Zerstörung einer Kommunikationsleitung zwischen den Schutzgeräten, die Überwachung der jeweiligen Leitung mit einem Ersatz-Schutzalgorithmus durchgeführt wird, der speziell dazu ausgebildet ist, die Schutzfunktion lediglich anhand der Messwerte von der eigenen Leitung durchzuführen. Hierdurch kann vermieden werden, dass die Schutzfunktion aufgrund der dann fehlenden Messwerte und/oder Signale des jeweils anderen Schutzgerätes zu fehlerhaften Entscheidungen über den Betriebszustand der jeweiligen Leitung führt. Somit ist bei dieser Weiterbildung des erfindungsgemäßen Verfahrens für den Betreiber eines elektrischen Energieversorgungsnetzes immer ein möglichst optimaler Schutz des Energieversorgungsnetzes gewährleistet. Konkret bedeutet dies, dass für den Betreiber eines Energieversorgungsnetzes, der für Parallelleitungen ein bestehendes Schutzsystem betreibt, das keine Anwendung des erfindungsgemäßen Verfahrens vorsieht, bei einer Aufrüstung des Schutzsystems zur Durchführung des erfindungsgemäßen Verfahrens keine Verschlechterung zum bisherigen Zustand eintreten kann. Bei bestehender Kommunikationsverbindung tritt nämlich durch Anwendung des Haupt-Schutzalgorithmus eine Verbesserung der Überwachung ein, während bei gestörter Übertragung über die Kommunikationsverbindung durch Anwendung des Ersatz-Schutzalgorithmus sozusagen auf den Status Quo zurückgeschaltet wird und damit keine Verschlechterung der Überwachung stattfindet.

Hierfür kann beispielsweise vorgesehen sein, dass beide Schutzalgorithmen, also der Haupt-Schutzalgorithmus und der Ersatz-Schutzalgorithmus parallel zueinander durchgeführt werden und durch die Überwachung der Kommunikationsverbindung lediglich entschieden wird, welche Ergebnisse verwendet werden sollen. In diesem Fall werden bei funktionstüchtiger Kommunikationsverbindung die Ergebnisse des Haupt-Schutzalgorithmus, bei gestörter Kommunikationsverbindung die Ergebnisse des Ersatz-Schutzalgorithmus verwendet. Hierdurch kann eine nahtlose Umschaltung zwischen den beiden Schutzalgorithmen gewährleistet werden.

Das erfindungsgemäße Verfahren kann bei verschiedenen Schutzfunktionen zur Steigerung der Zuverlässigkeit und Selektivität eingesetzt werden.

Eine Ausführungsform des erfindungsgemäßen Verfahrens sieht vor, dass die Schutzgeräte untereinander Betriebsstatussignale austauschen, die zumindest angeben, ob die von dem jeweiligen Schutzgerät überwachte Leitung komplett eingeschaltet oder komplett ausgeschaltet ist. Während eines einpoligen Fehlers auf der eigenen Leitung speichert das entsprechende Schutzgerät einen Verlauf von Strom- und Spannungsmesswerten ab und überprüft das Betriebsstatussignal des benachbarten Schutzgeräts. Sofern die Prüfung ergibt, dass die parallele Leitung komplett ausgeschaltet ist, empfängt das Schutzgerät, das den Fehler auf seiner Leitung erkannt hat, von einem am anderen Ende derselben Leitung angeordneten weiteren Schutzgerät, das ebenfalls die an seinem Ende während des Fehlers erfassten Strom- und Spannungsmesswerte abgespeichert hat, diese abgespeicherten Strom- und Spannungsmesswerte und berechnet mit den empfangenen und den eigenen abgespeicherten Strom- und Spannungsmesswerten einen Fehlerort, der angibt, an welcher Stelle der Leitung der Fehler aufgetreten ist. Das Schutzgerät bestimmt anhand des berechneten Fehlerortes einen Wert für eine Erdimpedanz, mit dem bei einer Bestimmung des Fehlerortes allein anhand der eigenen abgespeicherten Strom-und Spannungsmesswerte derselbe Fehlerort bestimmt worden wäre wie unter Verwendung der Strom- und Spannungsmesswerte von beiden Enden der Leitung, und stellt den berechneten Wert für die Erdimpedanz als Parameter für die Erdimpedanz zur Verfügung.

Ein ähnliches Verfahren zur Ermittlung der Erdimpedanz bei Einzelleitungen ist bereits aus der WO 2008/134998 A1 derselben Anmelderin bekannt.

Nunmehr kann durch Nutzung der Erfindung auch bei Parallelleitungen durch eine möglichst genaue Ermittlung des Parameters für die Erdimpedanz, den die Distanzschutzfunktion zur Berechnung der möglichen Erdfehlerschleifen (z.B. Phase A - Erde, Phase B - Erde, Phase C - Erde) benötigt, die Distanzschutzfunktion deutlich verbessert werden. Üblicherweise müssen solche Werte für die Erdimpedanz nämlich entweder durch aufwendige Messungen einmalig bestimmt werden oder es werden lediglich (vergleichsweise ungenaue) Erfahrungs- oder Tabellenwerte für die Erdimpedanz angesetzt.

Dagegen kann mit der hier vorgestellten Methode der Wert für die Erdimpedanz vergleichsweise genau und ohne die Notwendigkeit aufwändiger Messapparaturen bestimmt werden. Er beruht nämlich auf der Berechnung des konkreten Fehlerortes mittels eines zweiseitigen Fehlerortungsverfahrens, also einer Methode, bei der mit Messwerten von beiden Enden der fehlerbehafteten Leitung der Fehlerort bestimmt wird. Solche zweiseitigen Verfahren liefern deutlich genauere Ergebnisse als einseitige Fehlerortungsverfahren, bei denen nur die Messwerte eines Endes der Leitung zugrunde gelegt werden. Nachdem wie beschrieben ein genauer Wert für die Erdimpedanz ermittelt worden ist, kann - neben einer besseren Unterscheidung von internen und externen Fehlern und damit einer Erhöhung der Selektivität der Distanzschutzfunktion - auch mittels eines einseitigen Fehlerortungsverfahrens ein vergleichsweise genauer Fehlerort bestimmt werden.

In diesem Zusammenhang wird es als eine vorteilhafte Weiterbildung angesehen, wenn, sofern die Prüfung ergibt, dass die andere Leitung komplett eingeschaltet ist, das Schutzgerät, das den Fehler auf seiner Leitung erkannt hat, von dem am anderen Ende derselben Leitung angeordneten weiteren Schutzgerät, das die an seinem Ende während des Fehlers erfassten Strom- und Spannungsmesswerte abgespeichert hat, diese abgespeicherten Strom- und Spannungsmesswerte empfängt und mit den empfangenen und den eigenen abgespeicherten Strom- und Spannungsmesswerten einen Fehlerort berechnet, der angibt, an welcher Stelle der Leitung der Fehler aufgetreten ist. Das Schutzgerät bestimmt anhand des berechneten Fehlerortes und des bereitgestellten Parameters für die Erdimpedanz einen Wert für eine Koppelimpedanz, mit dem bei einer Bestimmung des Fehlerortes allein anhand der eigenen abgespeicherten Strom- und Spannungsmesswerte derselbe Fehlerort bestimmt worden wäre wie unter Verwendung der Strom- und Spannungsmesswerte von beiden Enden der Leitung. Der berechnete Wert wird für die Koppelimpedanz in dem Schutzgerät als Parameter für die Koppelimpedanz zur Verfügung gestellt.

Auf diese Weise lässt sich auch die durch elektrische und/oder elektromagnetische Beeinflussung der Parallelleitungen untereinander entstehende Koppelimpedanz vergleichsweise genau bestimmen. Diese Koppelimpedanz geht in die Berechnung der möglichen Fehlerschleifen zusätzlich ein und stellt, wenn beide Parallelleitungen eingeschaltet sind, einen nicht zu vernachlässigenden Anteil der Distanzschutzberechnung dar. Auf die beschriebene Weise kann die Koppelimpedanz, für die bisher lediglich Erfahrungswerte herangezogen werden, vergleichsweise genau bestimmt werden, da sie wiederum auf der Bestimmung des Fehlerortes mittels der (genauen) zweiseitigen Fehlerortungsmethode beruht. Der zuvor bereits berechnete genaue Wert für die Erdimpedanz wird zur Bestimmung der Koppelimpedanz herangezogen.

In diesem Zusammenhang besteht eine weitere vorteilhafte Weiterbildung des erfindungsgemäßen Verfahrens darin, dass bei einer Leitung, die teilweise als Freileitung und teilweise als Kabel ausgeführt ist, entweder unter Verwendung der Strom- und Spannungsmesswerte vom anderen Ende der Leitung oder lediglich anhand der eigenen gespeicherten Strom- und Spannungsmesswerte und der ermittelten Parameter für die Erdimpedanz und die Koppelimpedanz eine Bestimmung des Fehlerortes durchgeführt wird, und, sofern der Fehler auf dem als Freileitung ausgeführten Teil der Leitung liegt, eine automatische Wiedereinschaltung aktiviert wird, die bewirkt, dass der zur Abschaltung des Fehlers geöffnete Leistungsschalter nach Abwarten einer Wartezeit wieder geschlossen wird, während, sofern der Fehler auf dem als Kabel ausgeführten Teil der Leitung liegt, die automatische Wiedereinschaltung blockiert wird.

Im Falle eines Fehlers auf einer solchen "gemischten" Leitung, also einer teils als Freileitung, teils als unterirdisch verlegtes Kabel ausgeführten Leitung, muss nämlich hinsichtlich einer automatischen Wiedereinschaltung unterschieden werden, auf welchem der Teile (Freileitung oder Kabel) der Fehler aufgetreten ist. Während sich auf einer Freileitung ein Fehler oft nach einer kurzen Abschaltung der fehlerbehafteten Phase von selbst klärt (z.B. weil der Fehler auf einer temporären Berührung durch einen Baum oder auf Einwirkung durch Tiere beruhte), ist ein Fehler in einem Kabel üblicherweise auf eine Beschädigung des Kabels zurückzuführen, so dass eine automatische Wiedereinschaltung eher eine zusätzliche Gefährdung an der Beschädigungsstelle bedeuten würde.

Sofern durch eine genaue Fehlerortung, sei es durch ein zweiseitiges Verfahren oder eine einseitige Fehlerortung mit den genau berechneten Werten für Erd- und die Koppelimpedanz, eine Unterscheidung ermöglicht wird, auf welchem Teil der Leitung der Fehler liegt, kann entsprechend beim Freileitungsteil eine automatische Wiedereinschaltung aktiviert und beim Kabelteil eine solche blockiert werden.

In diesem Zusammenhang wird es zudem als vorteilhaft angesehen, wenn im Falle einer funktionsfähigen Kommunikationsverbindung zwischen den Schutzgeräten an beiden Enden der von dem Fehler betroffenen Leitung die Bestimmung des Fehlerortes anhand der Strom- und Spannungsmesswerte von beiden Enden der Leitung durchgeführt wird, während im Falle einer gestörten oder unterbrochenen Kommunikationsverbindung zwischen den Schutzgeräten an beiden Enden der von dem Fehler betroffenen Leitung die Bestimmung des Fehlerortes lediglich anhand der eigenen gespeicherten Strom- und Spannungsmesswerte und der ermittelten Parameter für die Erd- und die Koppelimpedanz durchgeführt wird.

Da nämlich üblicherweise auch bei genau berechneten Werten für die Erd- und die Koppelimpedanz durch das zweiseitige Fehlerortungsverfahren genauere Werte für den Fehlerort ermitteln werden, sollte dieses - im Falle einer bestehenden Kommunikationsverbindung zwischen den beiden Leitungsenden - bevorzugt verwendet werden. Lediglich beim Ausfall dieser Kommunikationsverbindung oder gestörter bzw. zu langsamer Übertragung der Messwerte kann auf die einseitige Fehlerortung mit den genauen Werten für Erd- und Koppelimpedanz zurückgegriffen werden.

Eine weitere Ausführungsform des erfindungsgemäßen Verfahrens sieht vor, dass zwischen den benachbarten Schutzgeräten hinsichtlich der einzelnen Phasen der jeweils eigenen Leitung erfasste Messwerte über die Kommunikationsverbindung ausgetauscht werden. Die Schutzfunktion des jeweiligen Schutzgeräts führt zur Auswahl, welche Phasen von dem Fehler betroffen sind, eine Impedanzmessung bezüglich einerseits der Leiter-Leiter-Schleifen und der Leiter-Erde-Schleifen der jeweils eigenen Leitung und andererseits bezüglich durch Kombination von Phasen beider Leitungen entstehender gemischter Leiter-Leiter-Schleifen durch und schließt durch Vergleich der Schleifen-Impedanzen untereinander und/oder mit einem jeweiligen Schleifen-Impedanz-schwellenwert auf die jeweils fehlerbehaftete Schleife.

Hierdurch können neben Fehlern, von denen jeweils nur eine der Leitungen betroffen ist, auch sogenannte Intersystemfehler ("Inter-System-Fault"), bei denen ein Fehler zwischen Phasen beider Leitungen auftritt, erkannt und selektiv abgeschaltet werden.

Außerdem kann konkret vorgesehen sein, dass die Schutzfunktion zur Überprüfung, ob auf beiden Leitungen ein Erdkurzschluss vorliegt, die eigenen und die vom jeweils anderen Schutzgerät empfangenen Messwerte daraufhin untersucht, ob bezüglich einer oder mehrerer Phasen eine Stromüberhöhung im Vergleich zu anderen Phasen auftritt und bei einer Stromüberhöhung in einzelnen Phasen unterschiedlicher Leitungen auf einen Erdkurzschluss auf beiden Leitungen schließt.

Die oben genannte Aufgabe wird außerdem durch ein Schutzsystem zum Überwachen eines elektrischen Energieversorgungsnetzes gelöst mit einem ersten Schutzgerät, das mit einer ersten Leitung des Energieversorgungsnetzes zum Erfassen von den Betriebszustand der ersten Leitung charakterisierenden Messwerten in Verbindung steht, wobei das erste Schutzgerät über eine Kommunikationsverbindung mit einem benachbart angeordneten zweiten Schutzgerät verbunden ist, und wobei das zweite Schutzgerät mit einer parallel zu der ersten Leitung (11a) verlaufenden zweiten Leitung des Energieversorgungsnetzes zum Erfassen von den Betriebszustand der zweiten Leitung charakterisierenden Messwerten in Verbindung steht, die beiden Schutzgeräte jeweils eine Kommunikationseinrichtung umfassen, die dazu eingerichtet ist, die von den Schutzgeräten bezüglich ihrer jeweiligen Leitung erfassten Messwerte und/oder von diesen Messwerten abgeleitete Signale an das jeweils andere Schutzgerät zu übertragen, jedes Schutzgerät eine Steuereinrichtung aufweist, die zur Ausführung einer Schutzfunktion, insbesondere einer Distanzschutzfunktion, für die jeweilige Leitung unter Ausführung eines Haupt-Schutzalgorithmus eingerichtet ist, wobei das erste Schutzgerät zur Ausführung seines Haupt-Schutzalgorithmus die an der ersten Leitung erfassten Messwerte sowie die von dem zweiten Schutzgerät empfangenen Messwerte und/oder Signale heranzieht, und das zweite Schutzgerät zur Ausführung seines Haupt-Schutzalgorithmus die an der zweiten Leitung erfassten Messwerte sowie die von dem ersten Schutzgerät empfangenen Messwerte und/oder Signale heranzieht. Erfindungsgemäß ist bei einem solchen Schutzsystem vorgesehen, dass die Schutzfunktion eine Distanzschutzfunktion umfasst, die Steuereinrichtung des jeweiligen Schutzgeräts dazu eingerichtet ist, zur Durchführung der Distanzschutzfunktion mittels des Haupt-Schutzalgorithmus aus den an ihrer jeweiligen Leitung erfassten Messwerten komplexe Impedanzwerte zu berechnen und ein Fehlersignal zu erzeugen, wenn die Impedanzwerte innerhalb eines Auslösegebietes liegen, die Steuereinrichtungen dazu eingerichtet sind, zwischen den benachbarten Schutzgeräten an den einzelnen Phasen der jeweils eigenen Leitung erfasste Messwerte über die Kommunikationsverbindung auszutauschen, die Steuereinrichtungen dazu eingerichtet sind, die Schutzfunktion unter Berücksichtigung der eigenen Messwerte und der Messwerte vom jeweils anderen Schutzgerät eine Überprüfung durchzuführen, ob gleichzeitig auf beiden Leitungen ein Erdkurzschluss vorliegt, indem die Strommesswerte der einzelnen Phasen jeweils untereinander oder mit bestimmten Schwellenwerten verglichen werden, um einzelne Phasen beider Leitungen zu erkennen, in denen vergleichsweise hohe Ströme fließen, und ein gleichzeitig auf beiden Leitungen vorliegender Erdkurzschluss erkannt wird, wenn für die erkannten Phasen zusätzlich die komplexen Impedanzwerte in dem Auslösegebiet liegen, und die Steuereinrichtungen dazu eingerichtet sind, bei positivem Ergebnis der Überprüfung die Schutzfunktion eine Auslösung der entsprechenden Leistungsschalter nur bezüglich der von dem Fehler tatsächlich betroffenen Phasen der beiden Leitungen zu veranlassen.

Vorteilhafterweise handelt es sich bei der Kommunikationsverbindung zwischen den beiden Schutzgeräten um eine Breitband-Datenverbindung, die beispielsweise durch eine Glasfaserleitung gebildet sein kann. Hierdurch wird eine bidirektionale Übertragung der Messwerte nahezu in Echtzeit, also ohne signifikante Zeitverzögerung nach ihrer Erfassung, ermöglicht.

Eine weitere vorteilhafte Ausführungsform des erfindungsgemäßen Schutzsystems sieht vor, dass die erste und die zweite Leitung jeweils dreiphasige Leitungen eines dreiphasigen Energieversorgungsnetzes sind, beide Schutzgeräte jeweils eine Messwerterfassungseinrichtung aufweisen, die dazu eingerichtet ist, für jede Phase gesondert die Messwerte der jeweiligen Leitung zu erfassen, und die Kommunikationseinrichtungen der Schutzgeräte dazu eingerichtet sind, über die Kommunikationsverbindung für jede Phase die entsprechenden Messwerte und/oder Signale zu übertragen.

Weiterhin kann gemäß einer weiteren vorteilhaften Ausbildung des erfindungsgemäßen Schutzsystems vorgesehen sein, dass beide Schutzgeräte eine Zeitstempeleinrichtung aufweisen, die dazu eingerichtet ist, den an der jeweiligen Leitung erfassten Messwerten jeweils einen den Zeitpunkt ihrer Erfassung angebenden Zeitstempel zuzuordnen, und die Kommunikationseinrichtung dazu eingerichtet ist, gemeinsam mit den über die Kommunikationsverbindung übertragenen Messwerten jeweils die zugehörigen Zeitstempel zu übermitteln.

Eine weitere vorteilhafte Ausführungsform des erfindungsgemäßen Schutzsystems sieht außerdem vor, dass beide Schutzgeräte jeweils eine Kommunikationsüberwachungseinrichtung aufweisen, die dazu eingerichtet ist, die Funktionstüchtigkeit der Kommunikationsverbindung zu überwachen und ein Ausfallsignal abzugeben, wenn die Funktionstüchtigkeit der Kommunikationsverbindung nicht gewährleistet ist, und die Steuereinrichtung der Schutzgeräte dazu eingerichtet ist, bei vorliegendem Ausfallsignal zur Ausführung der Schutzfunktion für ihre jeweilige Leitung einen von dem Haupt-Schutzalgorithmus verschiedenen Ersatz-Schutzalgorithmus zu verwenden, der nur die an der jeweils eigenen Leitung erfassten Messwerte, nicht aber die von dem jeweils anderen Schutzgerät empfangenen Messwerte und/oder Signale heranzieht.

Die oben genannte Aufgabe wird schließlich auch durch ein elektrisches Schutzgerät zur Überwachung einer ersten Leitung eines elektrischen Energieversorgungsnetzes gelöst mit einer Messwerterfassungseinrichtung, die mit der ersten Leitung des Energieversorgungsnetzes zum Erfassen von den Betriebszustand der ersten Leitung charakterisierenden Messwerten verbindbar ist, und einer Kommunikationseinrichtung, über die eine Kommunikationsverbindung zwischen dem Schutzgerät und einem benachbart zu dem Schutzgerät angeordneten zweiten Schutzgerät herstellbar ist, wobei bei bestehender Kommunikationsverbindung zwischen den Schutzgeräten Messwerte und/oder von diesen Messwerten abgeleitete Signale zwischen den Schutzgeräten übertragen werden, das Schutzgerät eine Steuereinrichtung aufweist, die zur Ausführung einer Schutzfunktion, insbesondere einer Distanzschutzfunktion, für die erste Leitung unter Ausführung eines Haupt-Schutzalgorithmus eingerichtet ist, wobei das Schutzgerät zur Ausführung seines Haupt-Schutzalgorithmus die an der ersten Leitung erfassten Messwerte sowie die von dem zweiten Schutzgerät empfangenen Messwerte und/oder Signale bezüglich einer parallel zu der ersten Leitung verlaufenden zweiten Leitung heranzieht. Erfindungsgemäß ist vorgesehen, dass die Schutzfunktion eine Distanzschutzfunktion umfasst, die Steuereinrichtung des Schutzgeräts dazu eingerichtet ist, zur Durchführung der Distanzschutzfunktion mittels des Haupt-Schutzalgorithmus aus den an ihrer Leitung erfassten Messwerten komplexe Impedanzwerte zu berechnen und ein Fehlersignal zu erzeugen, wenn die Impedanzwerte innerhalb eines Auslösegebietes liegen, die Steuereinrichtung des Schutzgerätes dazu eingerichtet ist, mit der Steuereinrichtung eines benachbarten Schutzgerätes an den einzelnen Phasen der jeweils eigenen Leitung erfasste Messwerte über die Kommunikationsverbindung auszutauschen, die Steuereinrichtung des Schutzgerätes dazu eingerichtet ist, unter Berücksichtigung der eigenen Messwerte und der Messwerte vom anderen Schutzgerät eine Überprüfung durchzuführen, ob gleichzeitig auf beiden Leitungen ein Erdkurzschluss vorliegt, indem die Strommesswerte der einzelnen Phasen jeweils untereinander oder mit bestimmten Schwellenwerten verglichen werden, um einzelne Phasen beider Leitungen zu erkennen, in denen vergleichsweise hohe Ströme fließen, und ein gleichzeitig auf beiden Leitungen vorliegender Erdkurzschluss erkannt wird, wenn für die erkannten Phasen zusätzlich die komplexen Impedanzwerte in dem Auslösegebiet liegen, und die Steuereinrichtung des Schutzgerätes dazu eingerichtet ist, bei positivem Ergebnis der Überprüfung die Schutzfunktion eine Auslösung der entsprechenden Leistungsschalter nur bezüglich der von dem Fehler tatsächlich betroffenen Phasen der beiden Leitungen zu veranlassen.

Eine vorteilhafte Weiterbildung des erfindungsgemäßen Schutzgerätes sieht vor, dass das Schutzgerät eine Kommunikationsüberwachungseinrichtung aufweist, die dazu eingerichtet ist, die Funktionstüchtigkeit der Kommunikationsverbindung zu überwachen und ein Ausfallsignal abzugeben, wenn die Funktionstüchtigkeit der Kommunikationsverbindung nicht gewährleistet ist, und die Steuereinrichtung dazu eingerichtet ist, bei vorliegendem Ausfallsignal zur Ausführung der Schutzfunktion für ihre Leitung einen von dem Haupt-Schutzalgorithmus verschiedenen Ersatz-Schutzalgorithmus zu verwenden, der nur die an der ersten Leitung erfassten Messwerte, nicht aber die von dem zweiten Schutzgerät empfangenen Messwerte und/oder Signale heranzieht.

Die Erfindung wird im Folgenden anhand von Ausführungsbeispielen näher erläutert. Hierzu zeigen

Figur 1    eine schematische Ansicht eines Schutzsystems für Parallelleitungen;

Figur 2       eine schematische Ansicht einer Ausführung eines elektrischen Schutzgerätes;

Figur 3       eine schematische Ansicht einer weiteren Ausführung eines elektrischen Schutzgerätes;

Figur 4       eine weitere schematische Ansicht eines Schutzsystems für Parallelleitungen;

Figur 5       eine schematische Ansicht einer gemischten Leitung, die teils als Freileitung, teils als Kabel ausgeführt ist;

Figur 6       eine schematische Ansicht eines Schutzsystems zur Erkennung von Intersystemfehlern; und

Figur 7       eine schematische Ansicht eines Schutzsystems zur Erkennung von Doppelerdfehlern mit Beteiligung beider Leitungen.

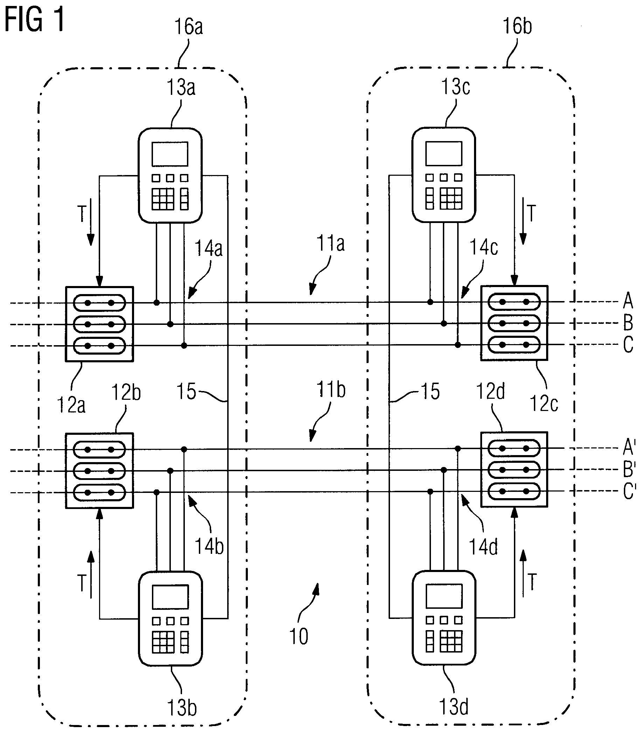

Figur 1 zeigt einen Netzabschnitt 10 eines ansonsten nicht näher dargestellten dreiphasigen elektrischen Energieversorgungsnetzes. Der Netzabschnitt 10 weist eine erste dreiphasige Leitung 11a mit Phasenleitern A, B, C und eine parallel dazu verlaufende zweite dreiphasige Leitung 11b mit Phasenleitern A', B', C' auf. Die parallel verlaufenden Leitungen 11a und 11b (nachfolgend einzeln oder gemeinsam auch "Parallelleitungen" genannt) sind an ihren Leitungsenden 16a, 16b jeweils durch dreipolige Leistungsschalter 12a, 12b, 12c, 12d begrenzt. An jedem Leitungsende 16a, 16b der Parallelleitungen befindet sich außerdem ein elektrisches Schutzgerät 13a, 13b, 13c, 13d. Konkret sind am in Figur 1 linken Leitungsende 16a der beiden Leitungen 11a und 11b die zueinander benachbarten Schutzgeräte 13a und 13b angeordnet, während am rechten Leitungsende 16b die zueinander benachbarten Schutzgeräte 13c und 13d angeordnet sind. Die Schutzgeräte 13a bis 13d erfassen an Messstellen 14a, 14b, 14c, 14d über nicht näher dargestellte Messwandler den Betriebszustand der jeweiligen Leitung 11a bzw. 11b charakterisierende Messwerte. Unter Berücksichtigung der erfassten Messwerte führen sie eine Schutzfunktion aus, indem sie einen Haupt-Schutzalgorithmus durchführen, der unter Berücksichtigung der erfassten Messwerte z.B. eine Entscheidung darüber trifft, ob auf der jeweils überwachten Leitung 11a bzw. 11b ein unzulässiger Betriebszustand vorliegt oder nicht. Sollte ein unzulässiger Betriebszustand erkannt worden sein, so gibt das jeweilige Schutzgerät 13a bis 13d an den jeweiligen Leistungsschalter 12a bis 12d ein auch als "Tripsignal" bezeichnetes Auslösesignal T ab, um eine oder mehrere Phasen vom übrigen Energieversorgungsnetz abzutrennen.

Da sich die parallel verlaufenden Leitungen 11a und 11b in räumlicher Nähe zueinander befinden, findet zwischen den beiden Leitungen 11a und 11b eine nicht zu vernachlässigende elektrische und/oder elektromagnetische Beeinflussung statt. Die elektrische Beeinflussung findet hierbei beispielsweise über Sammelschienen statt, mit denen beide Leitungen 11a, 11b in elektrischer Verbindung stehen, während die elektromagnetische Beeinflussung drahtlos infolge der engen Nachbarschaft der Parallelleitungen 11a, 11b auftritt. Eine elektromagnetische Beeinflussung ist insbesondere bei Freileitungen zu berücksichtigen, da unterirdische Kabel üblicherweise abgeschirmt sind. Insbesondere im Fall eines Fehlers auf einer der beiden Leitungen 11a oder 11b, der einen hohen Kurzschlussstrom auf der fehlerbehafteten Leitung hervorruft, tritt hinsichtlich der nicht von dem Fehler betroffenen ("gesunden") Leitung ein deutlicher Kopplungseffekt auf. Ein solcher Kopplungseffekt kann sich - sofern er bei der Durchführung des Haupt-Schutzalgorithmus nicht gesondert berücksichtigt wird - störend auf die Schutzfunktion der gesunden Leitung auswirken, so dass im Extremfall sogar ein ungewolltes Abschalten der gesunden Leitung hervorgerufen werden kann.

Um dies zu vermeiden, sind in dem in Figur 1 gezeigten Schutzsystem jeweils benachbarte Schutzgeräte 13a und 13b bzw. 13c und 13d eines Leitungsendes 16a bzw. 16b über eine Kommunikationsverbindung 15 miteinander verbunden. Über die Kommunikationsverbindung 15 werden zwischen den benachbarten Schutzgeräten 13a und 13b bzw. 13c und 13d an der jeweiligen Leitung 11a und 11b erfasste Messwerte und/oder von diesen Messwerten mittels des jeweiligen Schutzgeräts abgeleitete Signale, wie z.B. Statussignale, die einen Betriebszustand der jeweiligen Leitung angeben, ausgetauscht. So werden z.B. an dem linken Leitungsende 16a dem Schutzgerät 13a die von dem Schutzgerät 13b an der zweiten Leitung 11b erfassten Messwerte und/oder von diesen abgeleitete Signale zugeführt, so dass dessen Haupt-Schutzalgorithmus seine Schutzfunktion zur Überwachung des Betriebszustandes der ersten Leitung 11a unter Verwendung einerseits der an der Messstelle 14a der ersten Leitung 11a von dem Schutzgerät 13a selbst erfassten Messwerte und andererseits der von dem Schutzgerät 13b an der Messstelle 14b der zweiten Leitung 11b erfassten Messwerte und/oder der von diesen Messwerten abgeleiteten Signale durchführen kann.

Durch die direkte Berücksichtigung der jeweils durch die andere Parallelleitung hervorgerufenen Kopplungseinflüsse kann der Haupt-Schutzalgorithmus genauere Ergebnisse bestimmen, so dass z.B. eine zuverlässigere und selektivere Abschaltung genau derjenigen Phasen der Leitungen 11a bzw. 11b vorgenommen werden kann, die tatsächlich von einem Fehler betroffen sind, während solche Phasen, auf denen lediglich aufgrund der Kopplungseffekte scheinbar unzulässige Betriebszustände erkannt werden, eingeschaltet bleiben.

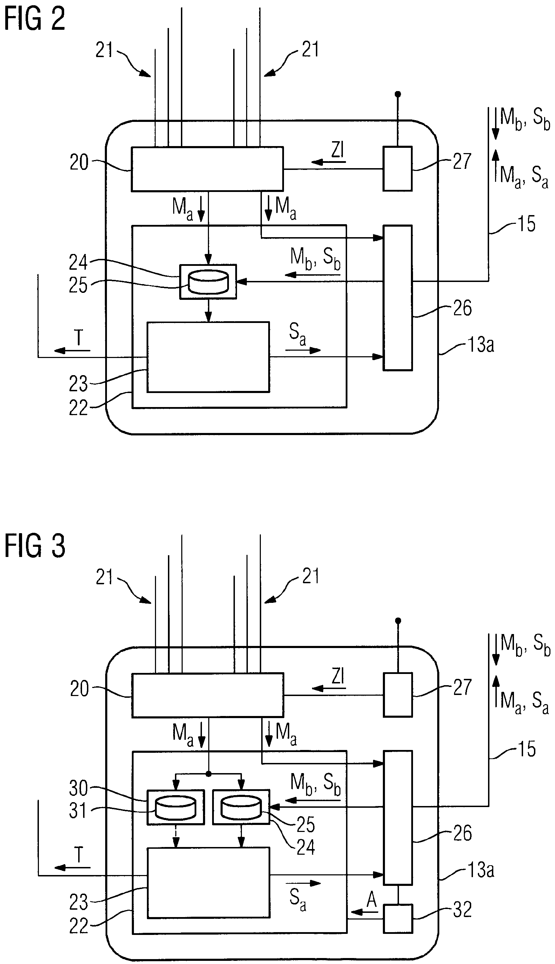

In Figur 2 ist beispielhaft das elektrische Schutzgerät 13a aus Figur 1 detaillierter dargestellt. Die übrigen Schutzgeräte 13b, 13c, 13d sind entsprechend aufgebaut, so dass die Erläuterung der Funktionsweise des Schutzgerätes 13a beispielhaft für die Funktionsweise aller Schutzgeräte 13a bis 13d steht. Das Schutzgerät 13a weist eine Messwerterfassungseinrichtung 20 auf, die über elektrische Verbindungsleitungen 21 mit Sensoren an der in Figur 2 nicht dargestellten Messstelle 14a der ersten Leitung 11a verbunden sind. Bei solchen Sensoren kann es sich beispielsweise um primäre Strom- und Spannungswandler handeln, die ausgangsseitig zu dem an der Messstelle 14a in der jeweiligen Phase fließenden Strom bzw. zu der an der Messstelle 14a in der jeweiligen Phase anliegenden Spannung proportionale Strom- bzw. Spannungssignale abgeben und der Messwerterfassungseinrichtung 20 des Schutzgerätes 13a zuführen. Die Messwerterfassungseinrichtung 20 kann beispielsweise sekundäre Strom- bzw. Spannungswandler aufweisen, um die noch vergleichsweise hohen Niveaus der von den Primärwandlern abgegebenen Strom- bzw. Spannungssignale auf derart niedrige Strom- bzw. Spannungsniveaus umzusetzen, dass eine gefahrlose Weiterverarbeitung in dem Schutzgerät 13a stattfinden kann.

Weiterhin kann die Messwerterfassungseinrichtung 20 Analog-Digitalumsetzer aufweisen, die eine Analog-Digital-Umsetzung der von den sekundären Strom- bzw. Spannungswandlern abgegebenen Messsignale unter Bildung digitaler Messwerte $M_a$ vornehmen. Die Messwerterfassungseinrichtung 20 kann ferner digitale Filtereinrichtungen aufweisen, um den Verlauf der so erzeugten digitalen Messwerte $M_a$ einer digitalen Filterung zu unterziehen, beispielsweise um mögliche Störeinflüsse zu entfernen, die bei der Messwerterfassung und/oder -umwandlung aufgetreten sein können, oder um aus den Messwerten komplexe Strom- und Spannungszeiger zu berechnen.

In einer Ausführungsform kann das Schutzgerät 13a außerdem eine Zeitstempeleinrichtung 27 aufweisen, bei der es sich beispielsweise um einen GPS-Empfänger handeln kann, der ein externes Zeitsignal empfängt und eine mikrosekundengenaue Zeitinformation ZI an die Messwerterfassungseinrichtung 20 abgibt. Anhand dieser Zeitinformation ZI kann eine Zeitstempelung der Messwerte $M_a$ vorgenommen werden, d. h. es kann jedem Messwert $M_a$ eine seinen Erfassungszeitpunkt angebende Zeitinformation ZI zugeordnet werden.

Die so erzeugten und gegebenenfalls zeitgestempelten Messwerte $M_a$ werden einer Steuereinrichtung 22 des Schutzgerätes 13a zugeführt, die mit einer Recheneinrichtung 23, beispielsweise einer CPU und/oder einem digitalen Signalprozessor eine Gerätesoftware in Form eines in einem Speicherbereich 24 abgespeicherten Haupt-Schutzalgorithmus 25 durchführt. Der Haupt-Schutzalgorithmus ist dazu eingerichtet, eine Schutzfunktion zur Überwachung der ersten Leitung 11a durchzuführen. Wie in Figur 2 schematisch angedeutet, verarbeitet der Haupt-Schutzalgorithmus 25 unter anderem die von der Messwerterfassungseinrichtung 20 abgegeben Messwerte $M_a$, die an der Messstelle 14a der ersten Leitung 11a erfasst worden sind.

Das Schutzgerät 13a weist weiterhin eine Kommunikationseinrichtung 26 auf, die über eine Kommunikationsverbindung 15, die als eine drahtgebundene Verbindung (z.B. eine Glasfaserkommunikationsleitung) oder eine drahtlose Verbindung (z.B. Funk, WLAN) ausgebildet sein kann, mit einer entsprechenden Kommunikationseinrichtung des benachbarten Schutzgeräts 13b in Verbindung steht. Über die Kommunikationsverbindung 15 tauschen die beiden Schutzgeräte 13a und 13b Messwerte in der Weise aus, dass die von der Messwerterfassungseinrichtung 20 bereitgestellten Messwerte $M_a$ über die Kommunikationseinrichtung 26 und die Kommunikationsverbindung 15 an das benachbarte Schutzgerät 13b übertragen werden, während die von diesem benachbarten Schutzgerät 13b an der Messstelle 14b der zweiten Leitung 11b erfassten Messwerte $M_b$ über die Kommunikationsverbindung 15 an die Kommunikationseinrichtung 26 des ersten Schutzgeräts 13a übertragen werden. Zusätzlich oder alternativ zu den Messwerten können zwischen den benachbarten Schutzgeräten 13a, 13b auch von den Messwerten an der jeweils eigenen Leitung abgeleitete Signale ausgetauscht werden. Im Schutzgerät 13a werden dazu die eigenen Messwerte $M_a$ der Recheneinrichtung 23 zugeführt, die diese Messwerte $M_a$ auswertet und Signale $S_a$ erzeugt, die z.B. einen Betriebszustand der eigenen Leitung 11a (z.B. Fehler in einem Phasenleiter der Leitung 11a) angeben. Diese Signale werden von der Recheneinrichtung 23 der Kommunikationseinrichtung 26 zugeführt und über die Kommunikationsverbindung 15 an das benachbarte Schutzgerät 13b übertragen. In entsprechender Weise können auch von dem Schutzgerät 13b durch Auswertung der Messwerte $M_b$ Signale $S_b$ erzeugt und an das Schutzgerät 13a übertragen werden.

Die Kommunikationsverbindung 15 sollte möglichst eine breitbandige Datenübertragung in Vollduplex-Betrieb ermöglichen, so dass die Messwerte $M_a$ und $M_b$ und/oder die Signale $S_a$, $S_b$ nahezu in Echtzeit, d. h. ohne signifikante Verzögerung nach ihrer Erfassung bzw. Erzeugung, zum jeweils anderen Schutzgerät übermittelt werden.

Die von der Kommunikationseinrichtung 26 des Schutzgerätes 13a empfangenen Messwerte $M_b$ und/oder Signale $S_b$ des Schutzgerätes 13b werden an die Steuereinrichtung 22 weitergeleitet und, wie in Figur 2 schematisch angedeutet, neben den Messwerten $M_a$ dem Haupt-Schutzalgorithmus 25 zur Verfügung gestellt. Der Haupt-Schutzalgorithmus 25 kann folglich auf Grundlage der von dem Schutzgerät 13a selbst erfassten Messwerte $M_a$ und der von dem benachbarten Schutzgerät 13b übermittelten Messwerte $M_b$ und/oder Signale $S_b$ die Schutzfunktion ausführen, also z.B. eine Entscheidung über den auf der ersten Leitung 11a vorliegenden Betriebszustand treffen. Durch Berücksichtigung der Messwerte $M_b$ und/oder Signale $S_b$ des benachbarten Schutzgerätes 13b können bei Durchführung des Haupt-Schutzalgorithmus 25 die durch die elektrische und/oder elektromagnetische Kopplung von der Parallelleitung auf die erste Leitung 11a einwirkenden Effekte kompensiert werden, so dass die Steuereinrichtung 22 z.B. eine zuverlässige und selektive Entscheidung darüber treffen kann, ob eine oder mehrere der Phasen der ersten Leitung 11a von einem Fehler betroffen sind oder nicht. Erkennt die Steuereinrichtung 22 auf der überwachten Leitung 11a tatsächlich einen unzulässigen Betriebszustand, so gibt sie das Auslöse- bzw. Tripsignal T an den Leistungsschalter 12a (s. Figur 1) ab, um diesen zum Öffnen der die jeweilige fehlerbehaftete Phase betreffenden Schaltkontakte zu veranlassen.

In Figur 3 ist ein zweites Ausführungsbeispiel des Schutzgerätes 13a gezeigt, das weitgehend dem ersten Ausführungsbeispiel gemäß Figur 2 entspricht, weswegen übereinstimmende Komponenten mit denselben Bezugszeichen gekennzeichnet sind. Die Funktionsweise der übereinstimmenden Komponenten entspricht der bezüglich Figur 2 bereits erläuterten Funktionsweise und soll daher an dieser Stelle nicht nochmals erläutert werden, so dass hier lediglich die Unterschiede zwischen den beiden Ausführungsbeispielen herausgestellt werden.

Im Gegensatz zum ersten Ausführungsbeispiel gemäß Figur 2 weist das Schutzgerät 13a des zweiten Ausführungsbeispiels gemäß Figur 3 einen zweiten Speicherbereich 30 auf, in dem ein weiterer Bestandteil der Gerätesoftware des Schutzgerätes 13a in Form eines Ersatz-Schutzalgorithmus 31 abgespeichert ist. Der Ersatz-Schutzalgorithmus 31 ist speziell dazu ausgelegt, lediglich anhand der an der Messstelle 14a von dem Schutzgerät 13a selbst erfassten Messwerte $M_a$ die Schutzfunktion möglichst genau durchzuführen, also z.B. eine mögliehst genaue Entscheidung über den auf der Leitung 11a vorliegenden Betriebszustand zu treffen, ohne die von der parallelen Leitung 11b bewirkten elektrischen und/oder elektromagnetischen Kopplungen zu berücksichtigen. Der Haupt-Schutzalgorithmus 25 und der Ersatz-Schutzalgorithmus 31 sind also zur Durchführung derselben Schutzfunktion eingerichtet, jedoch kann sich der Haupt-Schutzalgorithmus 25 sozusagen auf eine breitere Messwertbasis stützen.

Bei dem Ausführungsbeispiel gemäß Figur 3 ist außerdem eine Kommunikationsüberwachungseinrichtung 32 vorgesehen, die mit der Kommunikationseinrichtung 26 gekoppelt oder ein Bestandteil davon ist, und die Funktionstüchtigkeit der Kommunikationsverbindung 15 zwischen den Schutzgeräten 13a und 13b, die für die Überwachung auch die jeweiligen Kommunikationseinrichtungen der Schutzgeräte umfasst, überprüft und ein Ausfallsignal A erzeugt, falls die Kommunikation zwischen den Schutzgeräten 13a und 13b gestört oder unterbrochen ist. Erkennt die Kommunikationsüberwachungseinrichtung 32 eine gestörte oder eine unterbrochene Kommunikation zwischen den beiden Schutzgeräten 13a, 13b, so gibt sie das Ausfallsignal A an die Steuereinrichtung 22 ab, die daraufhin den Ersatz-Schutzalgorithmus 31 anstelle des Haupt-Schutzalgorithmus 25 durchführt, da in diesem Fall keine oder keine verlässlichen Messwerte $M_b$ und/oder Signale $S_b$ des benachbarten Schutzgerätes 13b mehr zur Verfügung stehen. Da der Ersatz-Schutzalgorithmus 31 speziell dafür ausgelegt ist, die Schutzfunktion ausschließlich anhand der von dem Schutzgerät 13a selbst erfassten Messwerte $M_a$ auszuführen, kann durch diesen automatischen Wechsel auf den Ersatz-Schutzalgorithmus 31 trotz unterbrochener oder gestörter Kommunikationsverbindung 15 eine ausreichend zuverlässige Weiterfunktion des Schutzgerätes 13a gewährleistet werden.

Um den Wechsel zwischen dem Haupt-Schutzalgorithmus 25 und dem Ersatz-Schutzalgorithmus 31 möglichst nahtlos durchführen zu können, kann beispielsweise vorgesehen sein, dass beide Schutzalgorithmen ständig parallel durchgeführt werden und je nach Zustand der Kommunikationsverbindung 15 die Ergebnisse des Haupt-Schutzalgorithmus 25 bzw. des Ersatz-Schutzalgorithmus 31 verwendet werden.

Eine Überwachung der Kommunikationsverbindung 15 kann beispielsweise durch ein sogenanntes "Hand-Shake-Verfahren" erfolgen, bei dem die Kommunikationsüberwachungseinrichtung 32 Testsignale an die Kommunikationsüberwachungseinrichtung des anderen Schutzgerätes 13b sendet und auf ein Quittierungssignal wartet. Bleibt dieses Quittierungssignal länger aus, so wird auf eine nicht funktionstüchtige Kommunikationsverbindung 15 geschlossen. Alternativ kann auch jede Kommunikationsüberwachungseinrichtung regelmäßig Testsignale an die jeweils andere Kommunikationsüberwachungseinrichtung senden. Bleibt der Empfang von Testsignalen längere Zeit aus, so schließt die jeweilige Kommunikationsüberwachungseinrichtung auf eine nicht funktionstüchtige Kommunikationsverbindung.

Sobald die Kommunikationsüberwachungseinrichtung 32 wieder eine funktionstüchtige Kommunikation zwischen den beiden Schutzgeräten 13a und 13b erkennt, und somit die übertragenen Messwerte $M_b$ und/oder Signale $S_b$ des Schutzgerätes 13b wieder zuverlässig empfangen werden können, kann die Schutzfunktion wieder durch den Haupt-Schutzalgorithmus 25 unter Berücksichtigung der eigenen Messwerte $M_a$ und der Messwerte $M_b$ und/oder Signale $S_b$ vom benachbarten Schutzgerät 13b durchgeführt werden.

Das beschriebene Schutzsystem für Parallelleitungen kann bei einer Vielzahl von Schutzfunktionen eine Verbesserung von Genauigkeit, Zuverlässigkeit und Selektivität der Ergebnisse des Haupt-Schutzalgorithmus bedeuten. Einige Beispiele solcher Schutzfunktionen werden nachfolgend näher erläutert.

Wie bereits eingangs erwähnt, kann es sich bei den von den Schutzgeräten 13a, 13b ausgeführten Schutzfunktionen beispielsweise um Distanzschutzfunktionen handeln.

Zunächst sei der im Schutzgerät 13a ausgeführte Haupt-Schutzalgorithmus erläutert. Eingangsseitig werden dem Haupt-Schutzalgorithmus als Messwerte $M_a$ (vergleiche Figuren 2 und 3) Strommesswerte $i_a$ und Spannungsmesswerte $u_a$ zugeführt, bei denen es sich üblicherweise um (digitale) Abtastwerte von Strom und Spannung handelt. Alternativ können jedoch beispielsweise auch komplexe Strom- und Spannungszeiger als Messwerte $M_a$ verwendet werden, die neben einer Angabe über die Amplitude des jeweiligen Messwertes auch eine Information über seinen Phasenwinkel enthalten. Der Haupt-Schutzalgorithmus wird üblicherweise in Form einer von der Steuereinrichtung des Schutzgerätes abgearbeiteten Software vorliegen.

Es werden aus jeweils zusammengehörenden - d.h. zu demselben Zeitpunkt erfassten - Strom- und Span-

nungsmesswerten komplexe Impedanzwerte $\underline{Z}_a$ berechnet. Die berechneten Impedanzwerte $\underline{Z}_a$ werden daraufhin überprüft, ob die Impedanzwerte $\underline{Z}_a$ innerhalb eines Auslösegebietes liegen. Ergibt die Überprüfung, dass die Impedanzwerte $\underline{Z}_a$ innerhalb des Auslösegebietes liegen, wird ein Fehlersignal $F_a$ erzeugt. Das Fehlersignal $F_a$ gibt hierbei vorzugsweise nicht nur das bloße Vorhandensein eines Fehlers auf der Leitung 11a, sondern auch die an dem Fehler beteiligte(n) Phase(n) der Leitung 11a an.

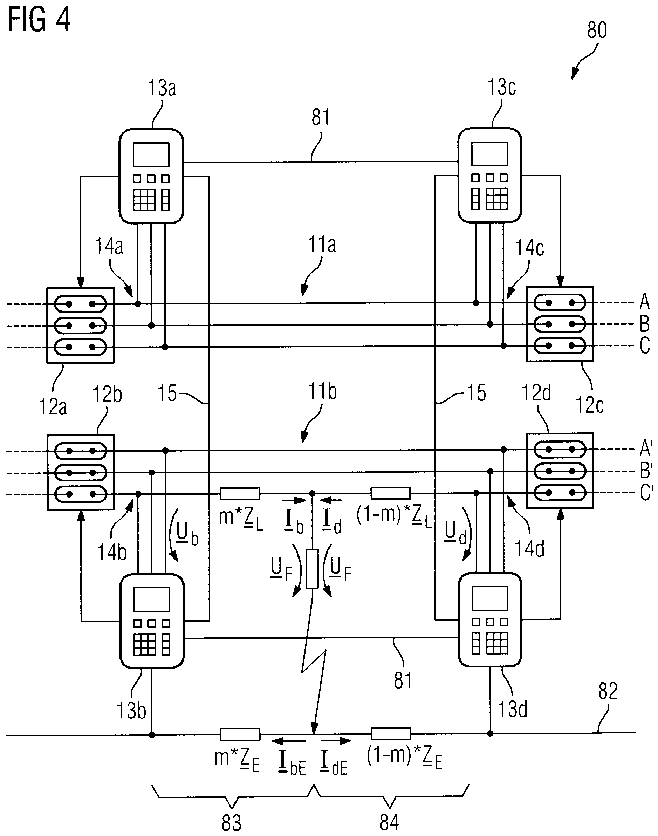

Figur 4 zeigt ein weiteres Ausführungsbeispiel eines Schutzsystems 80 für die beiden parallel zueinander verlaufenden Leitungen 11a und 11b. Mit dem Bezugszeichen 82 ist eine allen drei Phasenleitern A, B, C bzw. A', B', C' der beiden Leitungen 11a, 11b gemeinsame elektrische Erde gekennzeichnet. Zur Messung eines Erdstromes sind die Schutzgeräte 13a, 13b, 13c, 13d mit Erde 82 verbunden, dies ist jedoch aus Gründen der Übersichtlichkeit nur für die Schutzgeräte 13b und 13d explizit gezeigt.

Im Unterschied zu dem Schutzsystem nach Figur 1 sind bei dem Ausführungsbeispiel gemäß Figur 4 nicht nur die benachbarten Schutzgeräte (13a und 13b sowie 13c und 13d) miteinander über jeweils eine Kommunikationsverbindung 15 verbunden, sondern es besteht auch jeweils eine weitere Kommunikationsverbindung 81 zwischen den Schutzgeräten an beiden Enden einer jeden Leitung 11a bzw. 11b (konkret sind dies die Schutzgeräte 13a und 13c sowie 13b und 13d; die folgenden Ausführungen beziehen sich lediglich beispielhaft auf die Schutzgeräte 13b und 13d). Die weitere Kommunikationsverbindung 81 kann sowohl kabelgebunden als auch drahtlos ausgeführt sein und muss nicht kontinuierlich zwischen den beiden Schutzgeräten 13b und 13d bestehen oder aktiv sein. Beispielsweise ist es möglich, eine temporäre Kommunikationsverbindung in Form einer Funkverbindung zwischen den beiden Schutzgeräten 13b, 13d aufzubauen oder eine temporäre Telekommunikationsverbindung zwischen den beiden Schutzgeräten 13b, 13d über entsprechende Modemeinrichtungen aufzubauen. Bei der weiteren Kommunikationsverbindung 81 kann es sich außerdem um eine Kommunikationsverbindung vergleichsweise geringer Datenübertragungskapazität handeln.

Die Funktionsweise des in Figur 4 dargestellten Schutzsystems 80 soll im Folgenden näher erläutert werden. In Figur 4 ist die erste Leitung 11a z.B. zu Wartungszwecken komplett abgeschaltet; alle Pole der Leistungsschalter 12a und 12c befinden sich in der geöffneten Stellung. An späterer Stelle wird darauf Bezug genommen, dass alternativ die erste Leitung 11a auch komplett eingeschaltet sein kann; alle Pole der Leistungsschalter 12a und 12c befinden sich dann in der geschlossenen Stellung. Zwischenstellungen (z.B. einpolig geöffnete Leistungsschalter auf der ersten Leitung 11a) können zwar auftreten, werden jedoch für das im Folgende beschriebene Verfahren nicht verwendet.

Beispielhaft wird angenommen, dass zwischen der Phase C' der zweiten Leitung 11b und Erde 82 ein in Figur 4 durch ein Blitzsymbol angedeuteter Erdkurzschluss aufgetreten ist. Die Schutzgeräte 13b und 13d erkennen den aufgetretenen Kurzschluss, indem sie kontinuierlich die Strom- und Spannungsmesswerte an den jeweiligen Messstellen 14b und 14d erfassen und mit diesen zunächst die Impedanzen aller vorhandenen Schleifen, also der drei Leiter-Leiter-Schleifen (Phase A' zu Phase B', Phase A' zu Phase C', Phase B' zu Phase C') und der drei Leiter-Erde-Schleifen (Phase A' zu Erde, Phase B' zu Erde und Phase C' zu Erde) berechnen. Durch den Vergleich der ermittelten Impedanzen mit im Gerät gespeicherten Auslösegebieten wird die zweite Leitung 11b auf Fehler überprüft. Im Falle eines Fehlers wird die Fehlerart ermittelt, d. h., ob es sich um einen Leiter-Leiter-Kurzschluss oder einen Leiter-Erde-Kurzschluss handelt. Zusätzlich werden die an dem Fehler beteiligten Phasen bestimmt. Anhand der berechneten Impedanz kann außerdem auf den Fehlerort, an dem der Kurzschluss aufgetreten ist, geschlossen werden. Liegt ein Fehler vor und liegt der Fehlerort auf der zweiten Leitung 11b, so werden die betroffenen Phasen über die zugehörigen Leistungsschalter 12b, 12d vom übrigen Energieversorgungsnetz abgetrennt. In Figur 4 ist beispielhaft die von dem Erdkurzschluss betroffene Phase C' der zweiten Leitung 11b über die geöffnet dargestellten Kontakte der Leistungsschalter 12b und 12c abgeschaltet worden.

Im Falle des in Figur 4 dargestellten Leiter-Erde-Kurzschlusses fließt der Kurzschlussstrom von der betroffenen Phase C' der zweiten Leitung 11b über Erde 82 zum jeweiligen Schutzgerät 13b und 13d zurück. Die hierbei vorhandene Erdimpedanz ist üblicherweise nicht mit hoher Genauigkeit bekannt und musste bisher durch aufwändige Messungen, bei denen die Leitung 11b vom übrigen Netz abgetrennt sein musste, oder durch Abschätzungen oder Ablesungen aus Tabellen bestimmt und als Parameter in dem jeweiligen Schutzgerät eingegeben werden.

Sofern in dem parallel zur zweiten Leitung 11b verlaufenden ersten Leitung 11a ein Stromfluss stattfindet (z.B. wenn die Leitung 11a komplett eingeschaltet ist), beeinflussen sich beide Parallelleitungen, so dass in diesem Fall auch eine sogenannte Koppelimpedanz der Leitungen zu berücksichtigen ist. Der Wert der Koppelimpedanz kann bisher lediglich durch Simulationen oder Erfahrungswerte abgeschätzt werden oder wird sogar komplett vernachlässigt. Bei der Vernachlässigung der Koppelimpedanz kann jedoch hinsichtlich der Fehlerortung eine Ungenauigkeit von bis zu 40% auftreten. Im Folgenden soll daher ein Verfahren erläutert werden, das es ermöglicht, auf einfache Weise Einstellwerte für die Erdimpedanz und die Koppelimpedanz zu ermitteln.

Der Ort, an dem der Kurzschluss zwischen der Phase C' und Erde 82 aufgetreten ist, soll durch den Fehlerortwert m angegeben werden. Dafür wird die bekannte Maschenregel gemäß dem zweiten Kirchhoffschen Gesetz auf die in Figur 4 gezeigten Maschen 83 und 84, die jeweils zwischen dem Ort des Kurzschlusses und dem jeweiligen Schutzgerät 13b bzw. 13d vorliegen, angewendet. Hieraus ergibt sich für die Masche 83 zwischen dem ersten Schutzgerät 13b und dem Kurzschluss folgende Maschengleichung (1):

$$-\underline{U}_b + \underline{I}_{bL} \cdot m \cdot \underline{Z}_L + \underline{I}_{PE} \cdot m \cdot \underline{Z}_K + \underline{U}_F + \underline{I}_{bE} \cdot m \cdot \underline{Z}_E = 0 \qquad (1)$$

Hierbei bedeuten die Formelzeichen (vergleiche auch Figur 4):

$\underline{U}_b$: den von dem Schutzgerät 13b gemessenen Spannungszeiger, der die Spannung zwischen der Phase C' der zweiten Leitung 11b und Erde 82 angibt;

$\underline{I}_{bL}$: den von dem Schutzgerät 13b gemessenen Stromzeiger, der den in der Phase C' der zweiten Leitung 11b fließenden Strom angibt;

$m$: die Entfernung von dem Schutzgerät 13b zum Fehlerort bezogen auf die gesamte Länge der Leitung 11b (=Fehlerortwert) ;

$\underline{Z}_L$: die Mitsystemimpedanz der Phase C' der Leitung 11b;

$\underline{I}_{PE}$: den von dem benachbarten Schutzgerät 13a gemessenen Erdstromzeiger (nicht in Figur 4 gezeigt);

$\underline{Z}_K$: die Koppelimpedanz, die die Beeinflussung zwischen den beiden Leitungen 11a und 11b angibt (nicht in Figur 4 gezeigt);

$\underline{U}_F$: den Spannungsabfall am Fehlerort;

$\underline{I}_{bE}$: den von dem Schutzgerät 13b gemessenen Erdstromzeiger; und

$\underline{Z}_E$: die Erdimpedanz.

Für die zweite Masche 84 zwischen dem Schutzgerät 13d und dem Kurzschluss kann in entsprechender Weise die Maschengleichung (2) aufgestellt werden:

$$-\underline{U}_d + \underline{I}_{dL} \cdot (1-m) \cdot \underline{Z}_L + \underline{I}_{PE} \cdot (1-m) \cdot \underline{Z}_K + \underline{U}_F + \underline{I}_{dE} \cdot (1-m) \cdot \underline{Z}_E = 0 \qquad (2)$$

Hierbei bedeuten die zusätzlichen Formelzeichen (vergleiche auch Figur 4):

$\underline{U}_d$: den von dem Schutzgerät 13d gemessenen Spannungszeiger, der die Spannung zwischen der Phase C' der zweiten Leitung 11b und Erde 82 angibt;

$\underline{I}_{dL}$: den von dem Schutzgerät 13d gemessenen Stromzeiger, der den in der Phase C' der zweiten Leitung 11b fließenden Strom angibt; und

$\underline{I}_{dE}$: den von dem Schutzgerät 13d gemessenen Erdstromzeiger.

Unter Verwendung der jeweiligen Gleichung kann das Schutzgerät 13b bzw. 13d einen den Fehlerort angebenden Fehlerortwert m bestimmen. Bei bekannter Mitsystemimpedanz der Leitung müssen als zusätzliche Parameter die Einstellwerte für die Erdimpedanz und die Koppelimpedanz vorliegen.

Wenn die erste Leitung 11a komplett abgeschaltet ist (wie in Figur 4 dargestellt), findet keine Beeinflussung durch die Parallelleitung statt, so dass in diesem Fall auch keine Koppelimpedanz auftritt. Daher ist zunächst vorgesehen, dass die benachbarten Schutzgeräte 13a und 13b bzw. 13c und 13d über die Kommunikationsverbindung 15 Betriebszustandssignale austauschen, die angeben, ob die jeweils benachbarte Leitung 11a bzw. 11b komplett eingeschaltet oder komplett ausgeschaltet ist. Empfängt das Schutzgerät 13b ein Betriebszustandssignal, das angibt, dass die erste Leitung 11a komplett ausgeschaltet ist, so kann es die Berechnung des Einstellwertes für die Erdimpedanz anstoßen. In diesem Fall existiert keine Koppelimpedanz und die obigen Gleichungen (1) und (2) vereinfachen sich entsprechend:

$$-\underline{U}_b + \underline{I}_{bL} \cdot m \cdot \underline{Z}_L + \underline{U}_F + \underline{I}_{bE} \cdot m \cdot \underline{Z}_E = 0 \qquad (3)$$

bzw.

$$-\underline{U}_d + \underline{I}_{dL} \cdot (1-m) \cdot \underline{Z}_L + \underline{U}_F + \underline{I}_{dE} \cdot (1-m) \cdot \underline{Z}_E = 0 \qquad (4)$$

Bei bekannter Mitsystemimpedanz der Leitung ist in diesem Fall neben dem Fehlerortwert m also die Erdimpedanz die einzige Unbekannte.

Bei der ersten Inbetriebnahme der Schutzgeräte 13b und 13d kann als Anfangswert für den Parameter der Erdimpedanz beispielsweise ein aus Erfahrungswerten abgeleiteter Einstellwert verwendet werden. Für die Ermittlung eines möglichen Anfangswertes kann somit beispielsweise der Erfahrungswert herangezogen werden, dass das Verhältnis sowohl des Realteils als auch des Imaginärteils zwischen der Nullsystemimpedanz und der Mitsystemimpedanz einer elektrischen Energieübertragungsleitung üblicherweise ungefähr bei 1 liegt. Hieraus lässt sich ein Einstellwert für die Erdimpedanz abschätzen, der zwar nicht hochgenau ist, aber auf jeden Fall die Funktionstüchtigkeit der Schutzgeräte gewährleistet.

Beim Eintritt des Erdkurzschlusses auf der Phase C' der zweiten Leitung 11b, wird zunächst die betroffene Phase C' vom übrigen elektrischen Energieversorgungsnetz über die Leistungsschalter 12b und 12d isoliert.

Nach erfolgreicher Abschaltung der betroffenen Phase C' können die Strom- und Spannungsmesswerte, die während des Erdkurzschlusses aufgenommen und in internen Datenspeichern der Schutzgeräte 13b, 13d an beiden Enden der zweiten Leitung 11b gespeichert worden sind, über die weitere Kommunikationsverbindung 81 zwischen den Schutzgeräten 13b und 13d übertragen werden. Hierbei kann eine unidirektionale Übertragung stattfinden, bei der beispielsweise die von dem Schutzgerät 13d aufgenommenen Strom- und Spannungsmesswerte an das Schutzgerät 13b übertragen werden. Alternativ kann auch eine bidirektionale Übertragung stattfinden, bei der beide Schutzgeräte 13b und 13d ihre Strom- und Spannungsmesswerte an das jeweils andere Schutzgerät übertragen. Da der Erdkurzschluss zu diesem Zeitpunkt bereits abgeschaltet ist, kann die Übertragung der jeweiligen Strom- und Spannungsmesswerte in beliebig langer Zeit erfolgen, so dass für die Kommunikationsverbindung 81 eine Verbindung mit vergleichsweise geringer Datenübertragungskapazität ausreichend ist.

Mit den eigenen während des Erdkurzschlusses aufgenommenen Strom- und Spannungsmesswerten und den vom anderen Ende der Leitung 11b aufgenommenen Strom- und Spannungsmesswerten kann daraufhin von einem oder beiden Schutzgeräten 13b, 13d ein sogenannter zweiseitiger Fehlerortungsalgorithmus durchgeführt werden, mit dem sehr genau der Fehlerort, an dem der Erdkurzschluss aufgetreten ist, bestimmt werden kann. Hierzu sind aus dem Stand der Technik mehrere mögliche Fehlerortungsverfahren bekannt, beispielsweise kann der in der deutschen Patentschrift DE 4441334 C1 beschriebene zweiseitige Fehlerortungsalgorithmus verwendet werden. Unter Anwendung eines solchen zweiseitigen Fehlerortungsalgorithmus lässt sich der Fehlerortwert m genau bestimmen, der den auf die gesamte Leitungslänge bezogenen Fehlerort des Erdkurzschlusses angibt:

$$m = \frac{l_{b-F}}{l_{ges}} \qquad\qquad (5)$$

Hierbei bedeuten:

$l_{b-F}$: Strecke des Leitungsabschnitts von der Messstelle 14b bis zum Fehlerort;
$l_{ges}$: Länge der gesamten Leitung 11b.

Der Vorteil der Anwendung eines solchen zweiseitigen Fehlerortungsalgorithmus liegt insbesondere darin, dass er auf Strom- und Spannungsmesswerte von beiden Enden der Leitung 11b zurückgreift und daher ohne Kenntnis der Erdimpedanz durchgeführt werden kann.

Mit dem über den zweiseitigen Fehlerortungsalgorithmus ermittelten-Fehlerortwert m kann daraufhin in demjenigen Schutzgerät, in dem die Strommesswerte von beiden Enden vorliegen (also bei unidirektionaler Übertragung in einem Schutzgerät und bei bidirektionaler Übertragung in beiden Schutzgeräten) unter Anwendung der entsprechenden Maschengleichung (3) bzw. (4) der Wert für die Erdimpedanz bestimmt werden, der zu dem über den zweiseitigen Fehlerortungsalgorithmus berechneten Fehlerortwert m passt.

Mit anderen Worten wird hierbei diejenige Erdimpedanz berechnet, die bei Anwendung einer einseitigen Fehlerortung durch eines der Schutzgeräte 13b, 13d allein denselben Fehlerort ergeben hätte wie bei der zweiseitigen Fehlerortberechnung.

Hierzu wird beispielsweise Gleichung (3) für das Schutzgerät 13b derart umgestellt, dass sich folgende Gleichung ergibt:

$$\underline{Z}_E = \frac{\underline{U}_b - \underline{I}_{bL} \cdot m \cdot \underline{Z}_L - \underline{U}_F}{m \cdot \underline{I}_{bE}} \qquad\qquad (6)$$

Entsprechend wird durch Umstellung von Gleichung (4) für das andere Schutzgerät 13d folgende Gleichung als Berechnungsgleichung der Erdimpedanz ermittelt:

$$\underline{Z}_E = \frac{\underline{U}_d - \underline{I}_{dL} \cdot (1 \cdot m) \cdot \underline{Z}_L - \underline{U}_F}{(1-m) \cdot \underline{I}_{dE}} \qquad\qquad (7)$$

Einige Verfahren zur zweiseitigen Fehlerortung, wie beispielsweise das in der genannten Patentschrift DE 4441334 C1 beschriebene zweiseitige Fehlerortungsverfahren, liefern als Ergebnis auch einen Wert für den Spannungsabfall $\underline{U}_F$ am Fehlerort, so dass dieser Wert direkt in die jeweilige Berechnungsgleichung (6) bzw. (7) übernommen werden kann. Ist der Spannungsabfall $\underline{U}_F$ am Fehlerort nicht bekannt, so kann er ohne zu großen Einfluss auf das Endergebnis auch vernachlässigt und zu Null gesetzt werden.

Da in dem Fall der abgeschalteten Parallelleitung - also ohne Einfluss durch die Koppelimpedanz - die übrigen Werte, die für Gleichungen (3) bzw. (4) benötigt werden, entweder durch Messung oder als Leitungsparameter bekannt sind, kann problemlos die Erdimpedanz $\underline{Z}_E$ bestimmt werden. Die auf diese Weise berechnete Erdimpedanz kann im Folgenden als Einstellwert für den Parameter "Erdimpedanz" in den Schutzgeräten 13b und 13d verwendet werden.

Ist der Einstellwert für die Erdimpedanz auf die beschriebene Weise mit hoher Genauigkeit ermittelt worden, so kann bei einem folgenden Erdkurzschluss, der bei komplett eingeschalteter Parallelleitung (in Figur 4 nicht dargestellt) auftritt, der Einstellwert für die Koppelimpedanz bestimmt werden. Empfängt also das Schutzgerät 13b von seinem benachbarten Schutzgerät 13a während eines Erdkurzschlusses ein Betriebszustandssignal, das eine komplett eingeschaltete ersten Leitung 11a angibt, so führt es in der oben bereits beschriebenen Weise mit den während des Erdkurzschlusses erfassten Strom- und Spannungsmesswerten von beiden Enden der zweiten Leitung ein zweiseitiges Fehlerortungsverfahren aus, um den Fehlerortwert m zu ermitteln. Unter Verwendung des Fehlerortwertes m und des bereits ermittelten Wertes für die Erdimpedanz lässt sich dann nach Umstellung von Gleichung (1) der Wert für die Koppelimpedanz berechnen:

$$\underline{Z}_K = \frac{\underline{U}_b - \underline{U}_F}{m \cdot \underline{I}_{PE}} - \frac{\underline{I}_{bL} \cdot \underline{Z}_L + \underline{I}_{bE} \cdot \underline{Z}_E}{\underline{I}_{PE}} \qquad (8)$$

Hierzu ist es lediglich erforderlich, den vom benachbarten Schutzgerät 13a erfassten Erdstrom $\underline{I}_{PE}$ über die Kommunikationsverbindung 15 an das Schutzgerät 13b zu übertragen.

Entsprechend kann durch Umstellung von Gleichung (2) für das andere Schutzgerät 13d eine Berechnungsgleichung für die Koppelimpedanz ermittelt werden.

Sollte ein genauer Wert für die Erdimpedanz noch nicht ermittelt worden sein, z.B. weil die Parallelleitung bisher noch nie während eines Erdkurzschlusses auf der zweiten Leitung 11b ausgeschaltet gewesen ist, so können die während des Erdkurzschlusses an beiden Enden der zweiten Leitung 11b erfassten Strom- und Spannungsmesswerte auch für eine spätere Ermittlung der Koppelimpedanz gespeichert werden. Die Koppelimpedanz kann dann zu einem späteren Zeitpunkt bestimmt werden, wenn ein genauer Einstellwert für die Erdimpedanz vorliegt.

Findet eine Berechnung der Einstellwerte für die Erd- und die Koppelimpedanz in beiden Schutzgeräten 13b und 13d statt, so können die beiden Ergebnisse für die Erd- bzw. Koppelimpedanz miteinander verglichen werden. Treten zu hohe Abweichungen zwischen den jeweiligen Ergebnissen auf, so kann vorgesehen sein, dass aufgrund der Unsicherheit der Ergebnisse die berechneten Einstellwerte verworfen und nicht als Parameter für die Schutzgeräte 13b und 13d verwendet werden.

Es kann ferner vorgesehen sein, dass das Verfahren zur Berechnung der Einstellwerte für die Erd- und die Koppelimpedanz zunächst durch Abwarten einiger Erdkurzschlüsse mehrfach durchgeführt wird und dann ein Mittelwert aus den mehreren berechneten Einstellwerten gebildet wird. In diesem Fall wird dann der jeweilige Mittelwert als neuer Einstellwert für die Schutzgeräte 13b und 13d verwendet.

Ein besonderer Vorteil des beschriebenen Verfahrens besteht darin, dass die Berechnung der Einstellwerte für die Erd- und die Koppelimpedanz nicht zeitkritisch durchgeführt wird, d.h., dass zunächst eine Auslösung der jeweiligen Leistungsschalter 12b, 12d stattfindet, um den Fehler aus dem elektrischen Energieversorgungsnetz abzutrennen und erst danach - abhängig vom Zustand der Parallelleitung während des Erdkurzschlusses - die Berechnung des jeweiligen Einstellwertes stattfindet. Hierdurch werden die Anforderungen an die weitere Kommunikationsverbindung 81 vergleichsweise niedrig gehalten, da die Übertragungszeit zwischen den Schutzgeräten 13b und 13d keine Rolle spielt.

Die Schutzgeräte 13b und 13d können die Strom- und Spannungsmesswerte beispielsweise in nicht synchroner Weise aufnehmen. In diesem Fall muss als Algorithmus der zweiseitigen Fehlerortung ein solcher Algorithmus eingesetzt werden, der die Strom- und Spannungsmesswerte von den beiden Enden der Leitung 11b sozusagen nachträglich synchronisiert und dann den Fehlerortwert m berechnet. Bei einem solchen Verfahren muss üblicherweise eine kontinuierliche Kommunikationsverbindung zwischen den Schutzgeräten bestehen.

Es kann aber auch vorgesehen sein, dass die Schutzgeräte 13b und 13d ihre Strom- und Spannungsmesswerte in zeitsynchroner Weise aufnehmen, d. h. dass die Abtastung in den beiden Schutzgeräten synchron erfolgt. Hierzu weisen die Schutzgeräte 13b und 13d jeweils interne Zeitstempeleinrichtungen 27 (vgl. Figur 2) auf, die über einen externen Zeitgeber zueinander synchronisiert werden. Als externer Zeitgeber kann beispielsweise ein GPS-Satellit eingesetzt werden, der in regelmäßigen Abständen (z.B. im Sekundenabstand) ein Signal aussendet, aus dem ein absolutes Zeitsignal extrahiert werden kann. Die Schutzgeräte synchronisieren ihre Zeitstempeleinrichtungen 27 auf den externen Zeitgeber, indem sie die GPS-Signale empfangen und mittels nicht gezeigten GPS-Empfängerbausteinen das Zeitsignal aus dem GPS-Signal extrahieren. Anstelle eines GPS-Signals kann auch ein beliebiges anderes extern erzeugtes Zeitsignal verwendet werden. Den Strom- und Spannungsmesswerten wird ein Zeitstempel zugeordnet, der den Zeitpunkt ihrer Erfassung beispielsweise auf eine Mikrosekunde genau angibt, so dass eine Zuordnung der zueinander gehörenden Strom- und Spannungsmesswerte von beiden Enden der Leitung 11b für das zweiseitige Fehlerortungsverfahren in einfacher Weise möglich ist. Der Zeitstempel wird gemeinsam mit den jeweiligen Strom- und Spannungsmesswerten zwischen den Schutzgeräten 13b und 13d übertragen. Bei solchen zeitgestempelten Strom- und Spannungsmesswerten ist auch eine lediglich temporär bestehende Kommunikationsverbindung zwischen den Schutzgeräten ausreichend. Besteht keine Kommunikationsverbindung zwischen den Schutzgeräten, so ist es in diesem Fall auch möglich, die Strom- und Spannungsmesswerte manuell mit einem Datenträger zwischen den Schutzgeräten zu übermitteln.

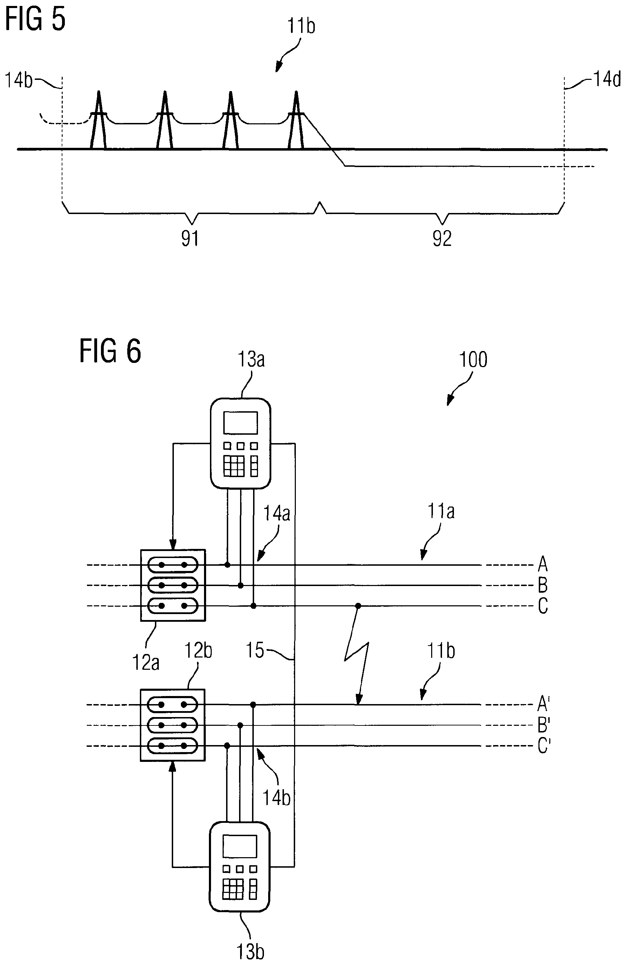

Mit den auf die beschriebene Weise genau ermittelten Werten für die Erdimpedanz und die Koppelimpedanz können einseitige Fehlerortungen sehr genau vorgenommen werden. Neben den Vorteilen einer zuverlässigen Unterscheidung von internen und externen Fehlern und einer genauen Angabe der Fehlerstelle auf der Leitung und damit verbundenem geringen manuellem Aufwand zur Fehlerstellensuche kann die genaue Angabe des Fehlerortes auch zur Steuerung der automatischen Wiedereinschaltung bei gemischten Leitungen, die teilweise als Freileitung und teilweise als Kabel ausgeführt sind, genutzt werden. Dies wird anhand von Figur 5 näher erläutert.

Figur 5 zeigt in höchst schematischer Darstellung eine Leitung 11b, die in Form einer gemischten Leitung ausgeführt ist. Nicht dargestellt ist eine parallel dazu verlaufende weitere Leitung (z.B. Leitung 11a, vgl. z.B. Figur 4). Ein erster Teil 91 der Leitung 11b ist als Freileitung ausgeführt, bei denen die Parallelleitungen über gemeinsame Freileitungsmasten geführt werden. Ein zweiter Teil 92 ist hingegen als unterirdisches Kabel ausgeführt.

Viele Fehler auf Freileitungen elektrischer Energieversorgungsnetze bestehen nur temporär, da sie beispielsweise durch Kontakt mit Tieren oder Pflanzen hervorgerufen sind. Daher sind solche Fehler häufig nach einer kurzen Abschaltphase bereits behoben. Dieser Erkenntnis haben die Hersteller von Schutzgeräten durch eine Funktion mit dem Namen "Automatische Wiedereinschaltung" oder "Kurzunterbrechung" Rechnung getragen. Hierbei wird der aufgrund eines Fehlers geöffnete Leistungsschalter nach einer kurzen Wartezeit (beispielsweise ca. 1 s) automatisch wieder geschlossen. Wenn der Fehler innerhalb dieser Wartezeit geklärt wurde, kann die Leitung daraufhin weiterbetrieben werden. Sollte der Fehler jedoch noch bestehen, erkennt ihn das jeweilige Schutzgerät erneut und der Leistungsschalter wird wieder geöffnet.

Diese Vorgehensweise ist für Freileitungen verwendbar, da dort temporäre Fehler auftreten können, nicht aber für unterirdische Kabel, bei denen im Fehlerfalle von einer weitergehenden Störung, z.B. einer Zerstörung der Isolation, ausgegangen werden muss. Daher darf die automatische Wiedereinschaltung nur bei Freileitungen, nicht aber bei Kabeln verwendet werden.

Durch eine präzise Angabe des Fehlerortes kann auch bei gemischten Leitungen wie der in Figur 5 dargestellten Leitung 11b eine sichere Unterscheidung eines Fehlers auf dem Freileitungsteil 91 und eines Fehlers auf dem Kabelteil 92 getroffen werden. Hierzu sind an lediglich angedeuteten Messstellen 14b und 14d an beiden Enden der Leitung 11b, an denen sich beispielsweise Unterstationen des Energieversorgungsnetzes befinden, Schutzgeräte 13b, 13d (vgl. z.B. Figur 4) vorgesehen, die eine Distanzschutzfunktion durchführen. Sie können entweder über eine zweiseitige Fehlerortung oder über eine einseitige Fehlerortung mit genau bestimmten Parametern für die Erdimpedanz und die Koppelimpedanz eine Ermittlung des Fehlerortes auf der Leitung 11b vornehmen.

Bevorzugt wird die zweiseitige Fehlerortung durchgeführt, solange eine Kommunikationsverbindung zwischen den Schutzgeräten an den beiden Messstellen 14b und 14d existiert. Wenn die Verbindung hingegen gestört ist, kann die Ermittlung des Fehlerortes auch mit der einseitigen Methode mit den genauen Parametern für Erdimpedanz und Koppelimpedanz erfolgen.

Durch die genaue Angabe des Fehlerortes kann darauf geschlossen werden, wo genau sich der Fehler auf der Leitung 11b befindet. Liegt er auf dem Freileitungsteil 91, so kann eine automatische Wiedereinschaltfunktion in den Schutzgeräten 13b, 13d aktiviert werden. Liegt er hingegen auf dem Kabelteil 92, so wird die automatische Wiedereinschaltfunktion blockiert bzw. deaktiviert, um keine zusätzliche Beschädigung oder Gefährdung durch das erneute Wiedereinschalten des Stromflusses auf einen bestehenden Fehler zu erzeugen.

Figur 6 zeigt ein weiteres Ausführungsbeispiels eines Schutzsystems 100 für Parallelleitungen, mit dem die Erkennung von sogenannten "Intersystemfehlern" durchgeführt wird, also Fehlern, an denen jeweils mindestens eine Phase beider Leitungen 11a und 11b beteiligt sind. In Figur 6 ist beispielhaft ein Intersystemfehler zwischen Phase C der ersten Leitung 11a und Phase A' der zweiten Leitung 11b dargestellt. Intersystemfehler können jedoch auch mehr als zwei Phasen betreffen (z.B. Phasen A und B der ersten Leitung 11a und Phase C' der zweiten Leitung 11b).

Üblicherweise führen die Haupt-Schutzalgorithmen der Distanzschutzfunktionen der Schutzgeräte 13a und 13b eine Messung von Strom- und Spannung an der jeweiligen Messstelle 14a bzw. 14b durch und bestimmen daraus für die jeweiligen Basis-Schleifen die Schleifenimpedanzen. Schutzgerät 13a berechnet anhand der an der Messstelle 14a der ersten Leitung aufgenommenen Strom- und Spannungsmesswerte folglich Schleifenimpedanzen für die folgenden Leiter-Leiter-Schleifen der ersten Leitung 11a:

- Phase A - Phase B (A-B),
- Phase A - Phase C (A-C),
- Phase B - Phase C (B-C).

Außerdem werden die Schleifenimpedanzen für die folgenden Leiter-Erde-Schleifen der ersten Leitung 11a bestimmt:

- Phase A - Erde (A-E),
- Phase B - Erde (B-E),
- Phase C - Erde (C-E).

Aus diesen Basis-Schleifenimpedanzen können durch Kombinationen auch Rückschlüsse auf komplexere Schleifen, z.B. Leiter-Leiter-Erde-Schleifen (z.B. A-B-E, A-C-E, B-C-E, A-B-C-E) oder 3-Leiter-Schleifen (A-B-C) gezogen werden. Die Schleifenimpedanzen der einzelnen Schleifen werden untereinander oder mit Schwellenwerten (z.B. numerischen Schwellenwerten oder Anregegebieten in der komplexen Zahlenebene) verglichen und es kann eine selektive, d.h. auf die jeweiligen Phasen bezogene, Entscheidung über das Vorliegen eines Fehlers getroffen werden, z.B. wenn die Schleifenimpedanzen den jeweiligen Schwellenwert unterschreiten oder eine Schleifenimpedanz deutlich kleiner ist als die anderen Schleifenimpedanzen.

Für das benachbarte Schutzgerät 13b an der zweiten Leitung 11b können anhand der an der Messstelle 14b erfassten Stromund Spannungsmesswerte entsprechend der Vorgehensweise bei der ersten Leitung 11a Basis-Schleifenimpedanzen für die folgenden Schleifen bestimmt werden:

- Phase A' - Phase B' (A'-B'),
- Phase A' - Phase C' (A'-C'),
- Phase B' - Phase C' (B'-C'),
- Phase A' - Erde (A'-E),
- Phase B' - Erde (B'-E),
- Phase C' - Erde (C'-E).

Daraus kann für die zweite Leitung 11b eine selektive Entscheidung hinsichtlich der von einem Fehler betroffenen Schleifen getroffen werden.

Im Falle von Parallelleitungen, insbesondere von auf denselben Freileitungsmasten verlaufenden Freileitungen, können neben Fehlern, die jeweils nur auf eine der beiden Leitungen bezogen sind, durch ungewollte elektrische Verbindungen zwischen den Phasen beider Leitungen 11a und 11b Intersystemfehler auftreten, die möglichst selektiv abgeschaltet werden sollen, d.h. es sollen nur die von dem Fehler betroffenen Phasen abgeschaltet werden. Bei dem in Figur 6 dargestellten Intersystemfehler C-A' sollen folglich nur die Phase C der ersten Leitung 11a und die Phase A' der zweiten Leitung 11b abgeschaltet werden. Die übrigen Phasen sind von dem Fehler nicht betroffen und können daher gefahrlos weiterbetrieben werden, wodurch die Stabilität des elektrischen Energieversorgungsnetzes aufrechterhalten wird.

Sofern die beiden benachbarten Schutzgeräte 13a und 13b jeweils lediglich die Messwerte ihrer eigenen Leitungen 11a bzw. 11b zur Berechnung der Schleifenimpedanzen verwenden, können solche Intersystemfehler nicht korrekt erkannt werden, so dass die Gefahr einer dreipoligen Abschaltung (anstelle jeweils einer selektiven einpoligen Abschaltung auf beiden Leitungen 11a und 11b) besteht.

Daher werden in dem Ausführungsbeispiel gemäß Figur 6 zwischen den Schutzgeräten 13a und 13b über die Kommunikationsverbindung 15 kontinuierlich zumindest die Strommesswerte aller Phasen ausgetauscht, so dass dem Schutzgerät 13a neben seinen eigenen, an der Messstelle 14a erfassten, Strom- und Spannungsmesswerten der Phasen A, B, C auch die von dem benachbarten Schutzgerät 13b an der Messstelle 14b erfassten Strommesswerte der Phasen A', B', C' bereitgestellt werden und umgekehrt. Da beide Leitungen 11a und 11b üblicherweise von derselben Sammelschiene gespeist werden, sollte die an den Messstellen 14a und 14b erfasste Spannung für beide Leitungen 11a und 11b übereinstimmen, so dass die Übertragung der Strommesswerte ausreichend ist. Alternativ ist es jedoch auch möglich, zusätzlich auch die genauen Spannungsmesswerte vom jeweils anderen Schutzgerät über die Kommunikationsverbindung 15 zu übertragen.

Mit den vom benachbarten Schutzgerät 13b empfangenen Stromund ggf. Spannungsmesswerten kann das Schutzgerät 13a folglich zusätzlich zu den sechs Basis-Schleifenimpedanzen der eigenen Phasen auch die Basis-Schleifenimpedanzen folgender Intersystemfehlerschleifen bestimmen:

- Phase A - Phase A' (A-A'),
- Phase A - Phase B' (A-B'),
- Phase A - Phase C' (A-C'),
- Phase B - Phase A' (B-A'),
- Phase B - Phase B' (B-B'),
- Phase B - Phase C' (B-C'),
- Phase C - Phase A' (C-A'),
- Phase C - Phase B' (C-B'),
- Phase C - Phase C' (C-C').

Entsprechend kann das Schutzgerät 13b mit den vom Schutzgerät 13a empfangenen Strom- und Spannungsmesswerten zusätzlich zu den sechs Basis-Schleifenimpedanzen der eigenen Phasen auch die Basis-Schleifenimpedanzen folgender Intersystemfehlerschleifen bestimmen:

- Phase A' - Phase A (A'-A),
- Phase A' - Phase B (A'-B),
- Phase A' - Phase C (A'-C),
- Phase B' - Phase A (B'-A),
- Phase B' - Phase B (B'-B),
- Phase B' - Phase C (B'-C),
- Phase C' - Phase A (C'-A),
- Phase C' - Phase B (C'-B),
- Phase C' - Phase C (C'-C).

Da üblicherweise durch eine Sammelschiene gleiche Phasen (z.B. Phasen A und A') der beiden Leitungen 11a und 11b bereits elektrisch gekoppelt sind, sollte sich die Berechnung der entsprechenden Fehlerschleifen erübrigen. Es kann jedoch Konstellationen (z.B. unterbrochene Sammelschienen) geben, in denen auch die Berechnung dieser Fehlerschleifen zweckmäßig ist.

Durch die Berechnung aller Basis-Schleifenimpedanzen sind beide Schutzgeräte 13a, 13b nunmehr in der Lage, auch Intersystemfehler zu erkennen und selektiv abzuschalten.

In einem bevorzugten Ausführungsbeispiel erkennen die in den Schutzgeräten vorhandenen Kommunikationsüberwachungseinrichtungen 32 (s. Figur 3) in dem Fall, dass die Kommunikationsverbindung 15 unterbrochen wird oder die Kommunikation gestört ist, den Ausfall und geben ein entsprechendes Ausfallsignal ab. Dadurch werden die Schutzgeräte dazu veranlasst, anstelle des Haupt-Schutzalgorithmus, bei dem auch die Intersystemfehlerschleifen geprüft werden, einen Ersatz-Schutzalgorithmus zu verwenden, bei dem nur die eigenen Fehlerschleifen geprüft werden. Hierdurch wird einerseits Rechenleistung eingespart, indem die mangels Messwerten von der Parallelleitung unvollständigen Intersystemfehlerschleifen nicht mehr überprüft werden. Außerdem werden Fehlentscheidungen aufgrund der fehlenden Messwerte von der Parallelleitung sicher vermieden, wenn die Intersystemfehlerschleifen aus der Überprüfung herausgenommen werden.

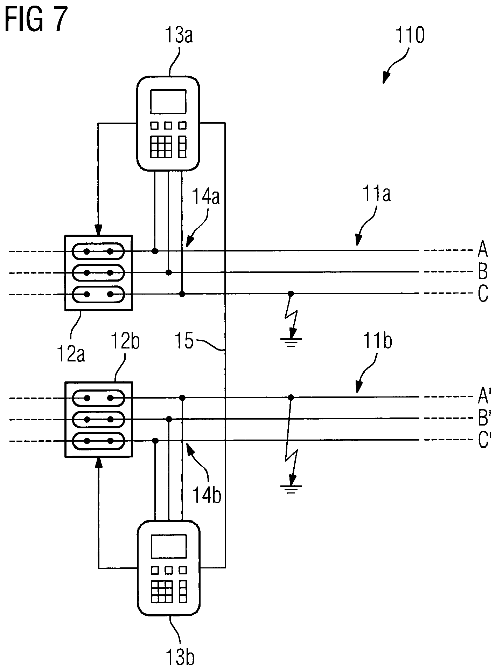

Figur 7 zeigt schließlich ein Ausführungsbeispiel eines Schutzsystems 110, das zur Erkennung von Doppelerdfehlern mit Beteiligung beider Leitungen 11a und 11b eingerichtet ist. Solche Fehler werden auch als Cross-Country-Faults bezeichnet. In Figur 7 sind hierzu lediglich beispielhaft Erdfehler bezüglich Phase C der ersten Leitung 11a und Phase A' der zweiten Leitung 11b dargestellt.

Solche Doppelerdfehler, also gleichzeitig (oder zumindest nahezu gleichzeitig) auftretende Einzel-Erdfehler (also Erdfehler, bei denen ein Kurzschluss zwischen einer einzelnen Phase und Erde auftritt) an beiden Parallelleitungen können bei der Impedanzbestimmung der unterschiedlichen Schleifen bei den jeweiligen Schutzgeräten 13a und 13b durch Koppeleffekte ungenaue Ergebnisse erzeugen, aus denen die einzelnen Schutzgeräte 13a und 13b fälschlicherweise auf einen Mehrphasenerdschluss ihrer eigenen Leitung schließen könnten, was eine mehrpolige Abschaltung zur Folge hätte.

Um dennoch eine selektive Erkennung der jeweils von dem Erdfehler betroffenen Phase durchführen zu können, werden bei dem Schutzsystem 110 gemäß Figur 7 die Messwerte, insbesondere die Strommesswerte die an den Messstellen 14a und 14b von den Schutzgeräten 13a und 13b aufgenommen werden, über die Kommunikationsverbindung 15 ausgetauscht. Anhand der eigenen und der vom jeweils anderen Schutzgerät 13a und 13b empfangenen Messwerte können die Schutzfunktionen der einzelnen Schutzgeräte 13a und 13b überprüfen, ob auf einen Fehlerzustand hinweisende Messwerte lediglich bezüglich einer der beiden Leitungen 11a oder 11b oder bezüglich beider Leitungen 11a und 11b auftreten. Beispielsweise werden dazu Strommesswerte bezüglich der Phasen A, B, C, A', B', C' jeweils untereinander oder mit bestimmten Schwellenwerten verglichen, um durch vergleichsweise hohe fließende Ströme auf einen Fehler in einzelnen Phasen beider Leitungen schließen zu können. Liegt gleichzeitig der entsprechende Impedanzzeiger für von einem solchen überhöhten Stromfluss betroffene Phasen im Auslösegebiet, so können von den Schutzgeräten 13a und 13b jeweils Auslösesignale an die entsprechenden Leistungsschalter 12a und 12b gesendet werden, um diese zum Abschalten der von einem Erdkurzschluss betroffenen Phasen zu veranlassen.

Im dargestellten Beispiel würden die Impedanzzeiger zumindest der fehlerbehafteten Phasen C und A' in den jeweiligen Auslösegebieten liegen; aufgrund von Koppeleffekten können auch weitere Impedanzzeiger der übrigen - nicht von einem Fehler betroffen - Phasen in den jeweiligen Auslösegebieten liegen. Aufgrund der Betrachtung der einzelnen Phasenströme der eigenen und des jeweils anderen Leitung 11a bzw. 11b können die Schutzgeräte 13a bzw. 13b jedoch darauf schließen, dass Erdkurzschlüsse bezüglich beider Leitungen 11a und 11b vorliegen müssen, da die Phasenströme in den Phasen C und A' deutlich überhöht sein werden. Auf diese Weise kann eine selektive Abschaltung nur der betroffenen Phasen C und A' veranlasst werden, ohne eine oder beide Leitungen unnötigerweise komplett abschalten zu müssen.

Die einzelnen bezüglich der Figuren 4 bis 7 beschriebenen Ausführungsbeispiele von unterschiedlichen Schutzfunktionen können einzeln oder in beliebiger Kombination in den Schutzgeräten eingesetzt werden, so dass ein umfassender Schutz von Parallelleitungen ermöglicht wird.

## Patentansprüche

1. Verfahren zum Überwachen eines mehrphasigen elektrischen Energieversorgungsnetzes, wobei

- ein erstes Schutzgerät (13a) mit einer ersten Leitung (11a) des Energieversorgungsnetzes zum Erfassen von den Betriebszustand der ersten Leitung (11a) charakterisierenden Messwerten in Verbindung steht, wobei das erste Schutzgerät (13a) über eine Kommunikationsverbindung (15) mit einem benachbart angeordneten zweiten Schutzgerät (13b) verbunden ist, und wobei
- das zweite Schutzgerät (13b) mit einer parallel zu der ersten Leitung (11a) verlaufenden zweiten Leitung (11b) des Energieversorgungsnetzes zum Erfassen von den Betriebszustand der zweiten Leitung (11b) charakterisierenden Messwerten in Verbindung steht,
- die beiden Schutzgeräte (13a, 13b) die von ihnen bezüglich ihrer jeweiligen Leitung (11a, 11b) erfassten Messwerte und/oder von diesen Messwerten abgeleitete Signale an das jeweils andere Schutzgerät (13b, 13a) übertragen,
- jedes Schutzgerät (13a, 13b) zur Ausführung einer Schutzfunktion, insbesondere einer Distanzschutzfunktion, für seine jeweilige Leitung (11a, 11b) unter Ausführung eines Haupt-Schutzalgorithmus (25) eingerichtet ist,
- das erste Schutzgerät (13a) zur Ausführung seines Haupt-Schutzalgorithmus (25) die an der ersten Leitung (11a) erfassten Messwerte sowie die von dem zweiten Schutzgerät (13b) empfangenen Messwerte und/oder Signale heranzieht, und
- das zweite Schutzgerät (13b) zur Ausführung seines Haupt-Schutzalgorithmus (25) die an der zweiten Leitung (11b) erfassten Messwerte sowie die von dem ersten Schutzgerät (13a) empfangenen Messwerte und/oder Signale heranzieht,

**dadurch gekennzeichnet, dass**

- die Schutzfunktion eine Distanzschutzfunktion umfasst, wobei die Schutzgeräte (13a, 13b) zur Durchführung der Distanzschutzfunktion mittels des Haupt-Schutzalgorithmus (25) aus den an ihrer jeweiligen Leitung (11a, 11b) erfassten Messwerten komplexe Impedanzwerte berechnen und ein Fehlersignal erzeugen, wenn die Impedanzwerte innerhalb eines Auslösegebietes liegen;
- zwischen den benachbarten Schutzgeräten (13a, 13b) an den einzelnen Phasen (A, B, C, A', B', C') der jeweils eigenen Leitung (11a, 11b) erfasste Messwerte über die Kommunikationsverbindung (15) ausgetauscht werden;
- die Schutzfunktion unter Berücksichtigung der eigenen Messwerte und der Messwerte vom jeweils anderen Schutzgerät (13a, 13b) eine Überprüfung durchführt, ob gleichzeitig auf beiden Leitungen (11a, 11b) ein Erdkurzschluss vorliegt, indem die Strommesswerte der einzelnen Phasen (A, B, C, A', B', C') jeweils untereinander oder mit bestimmten Schwellenwerten verglichen werden, um einzelne Phasen beider Leitungen zu erkennen, in denen vergleichsweise hohe Ströme fließen, und ein gleichzeitig auf beiden Leitungen (11a, 11b) vorliegender Erdkurzschluss erkannt wird, wenn für die erkannten Phasen zusätzlich die komplexen Impedanzwerte in dem Auslösegebiet liegen; und
- bei positivem Ergebnis der Überprüfung die Schutzfunktion eine Auslösung der entsprechenden Leistungsschalter (12a, 12b) nur bezüglich der von dem Fehler tatsächlich betroffenen Phasen (A, B, C, A', B', C') der beiden Leitungen (11a, 11b) veranlasst.

**2.** Verfahren nach Anspruch 1,
**dadurch gekennzeichnet, dass**

- die erste und die zweite Leitung (11a, 11b) jeweils dreiphasige Leitungen eines dreiphasigen Energieversorgungsnetzes sind,
- beide Schutzgeräte (13a, 13b) jeweils für jede Phase (A, B, C, A', B', C') gesondert die Messwerte der jeweiligen Leitung (11a, 11b) erfassen, und
- über die Kommunikationsverbindung (15) für jede Phase (A, B, C, A', B', C') die entsprechenden Messwerte und/oder von diesen Messwerten abgeleitete Signale übertragen werden.

**3.** Verfahren nach Anspruch 1 oder 2,
**dadurch gekennzeichnet, dass**

- beide Schutzgeräte (13a, 13b) eine Zeitstempeleinrichtung (21) aufweisen, mit der den an der jeweiligen Leitung (11a, 11b) erfassten Messwerten jeweils ein den Zeitpunkt ihrer Erfassung angebender Zeitstempel zugeordnet wird, und
- gemeinsam mit den über die Kommunikationsverbindung (15) übertragenen Messwerten jeweils die zugehörigen Zeitstempel übermittelt werden.

**4.** Verfahren nach einem der vorangehenden Ansprüche,
**dadurch gekennzeichnet, dass**

- beide Schutzgeräte (13a, 13b) jeweils eine Kommunikations-überwachungseinrichtung (32) aufweisen, die die Funktionstüchtigkeit der Kommunikationsverbindung (15) überwacht und ein Ausfallsignal abgibt, wenn die Funktionstüchtigkeit der Kommunikationsverbindung (15) nicht gewährleistet ist, und
- von den Schutzgeräten (13a, 13b) bei vorliegendem Ausfallsignal zur Ausführung der Schutzfunktion für ihre jeweilige Leitung (11a, 11b) ein von dem Haupt-Schutzalgorithmus (25) verschiedener Ersatz-Schutzalgorithmus (31) verwendet wird, der nur die an der jeweils eigenen Leitung (11a bzw. 11b) erfassten Messwerte, nicht aber die von dem jeweils anderen Schutzgerät (13a bzw. 13b) empfangenen Messwerte und/oder Signale heranzieht.

**5.** Verfahren nach einem der vorangehenden Ansprüche,
**dadurch gekennzeichnet, dass**

- die Schutzgeräte (13a, 13b) untereinander Betriebsstatussignale austauschen, die zumindest angeben, ob die von dem jeweiligen Schutzgerät (13a, 13b) überwachte Leitung (11a, 11b) komplett eingeschaltet oder komplett ausgeschaltet ist;
- während eines einpoligen Fehlers auf der eigenen Leitung (11a, 11b) das entsprechende Schutzgerät (13a, 13b) einen Verlauf von Strom- und Spannungsmesswerten abspeichert und das Betriebsstatussignal des benachbarten Schutzgeräts (13a, 13b) überprüft; und
- sofern die Prüfung ergibt, dass die benachbarte Leitung (11a, 11b) komplett ausgeschaltet ist, das Schutzgerät (13a, 13b), das den Fehler auf seiner Leitung (11a, 11b) erkannt hat, von einem am anderen Ende derselben Leitung (11a, 11b) angeordneten weiteren Schutzgerät (13c, 13d), das die an seinem Ende derselben Leitung (11a, 11b) während des Fehlers erfassten Strom- und Spannungsmesswerte abgespeichert hat, diese abgespeicherten Strom- und Spannungsmesswerte empfängt und mit den empfangenen und den eigenen abgespeicherten Strom-und Spannungsmesswerten einen Fehlerort berechnet, der angibt, an welcher Stelle der Leitung (11a, 11b) der Fehler aufgetreten ist;
- das betreffende Schutzgerät (13c, 13d) anhand des berechneten Fehlerortes einen Wert für eine Erdimpedanz bestimmt, mit dem bei einer Bestimmung des Fehlerortes allein anhand der eigenen abgespeicherten Strom- und Spannungsmesswerte derselbe Fehlerort bestimmt worden wäre wie unter Verwendung der Strom- und Spannungsmesswerte von beiden Enden der Leitung; und
- der berechnete Wert für die Erdimpedanz in dem Schutzgerät (13c, 13d) als Parameter für die Erdimpedanz zur Verfügung gestellt wird.

**6.** Verfahren nach Anspruch 5,
**dadurch gekennzeichnet, dass**

- sofern die Prüfung ergibt, dass die benachbarte Leitung (11a, 11b) komplett eingeschaltet ist, das Schutzgerät (13a, 13b), das den Fehler auf seiner Leitung (11a, 11b) erkannt hat, von dem am anderen Ende derselben Leitung (11a, 11b) angeordneten weiteren Schutzgerät (13c, 13d), das die an seinem Ende während des Fehlers erfassten Strom- und Spannungsmesswerte abgespeichert hat, diese abgespeicherten Strom- und Spannungsmesswerte empfängt und mit den empfangenen und den eigenen abgespeicherten Strom- und Spannungsmesswerten einen Fehlerort berechnet, der angibt, an welcher Stelle der Leitung (11a, 11b) der Fehler aufgetreten ist;

- das Schutzgerät (13a, 13b) anhand des berechneten Fehlerortes und des bereitgestellten Parameters für die Erdimpedanz einen Wert für eine Koppelimpedanz bestimmt, mit dem bei einer Bestimmung des Fehlerortes allein anhand der eigenen abgespeicherten Strom- und Spannungsmesswerte derselbe Fehlerort bestimmt worden wäre wie unter Verwendung der Strom-und Spannungsmesswerte von beiden Enden der Leitung (11a, 11b); und

- der berechnete Wert für die Koppelimpedanz in dem Schutzgerät (13a, 13b) als Parameter für die Koppelimpedanz zur Verfügung gestellt wird.

7. Verfahren nach Anspruch 5 oder 6,
**dadurch gekennzeichnet, dass**

- bei einer Leitung (z.B. 11b), die teilweise als Freileitung (91) und teilweise als Kabel (92) ausgeführt ist, unter Verwendung der Strom- und Spannungsmesswerte vom anderen Ende der Leitung (11b) oder lediglich anhand der eigenen gespeicherten Strom- und Spannungsmesswerte und der ermittelten Parameter für die Erdimpedanz und die Koppelimpedanz eine Bestimmung des Fehlerortes durchgeführt wird; und

- sofern der Fehler auf dem als Freileitung (91) ausgeführten Teil der Leitung (11b) liegt, eine automatische Wiedereinschaltung aktiviert wird, die bewirkt, dass der zur Abschaltung des Fehlers geöffnete Leistungsschalter nach Abwarten einer Wartezeit wieder geschlossen wird; und

- sofern der Fehler auf dem als Kabel (92) ausgeführten Teil der Leitung (11b) liegt, die automatische Wiedereinschaltung blockiert wird.

8. Verfahren nach Anspruch 7,
**dadurch gekennzeichnet, dass**

- im Falle einer funktionsfähigen Kommunikationsverbindung (81) zwischen den Schutzgeräten (z.B. 13b, 13d) an beiden Enden der von dem Fehler betroffenen Leitung (z.B. 11b) die Bestimmung des Fehlerortes anhand der Strom- und Spannungsmesswerte von beiden Enden der Leitung (11b) durchgeführt wird, und

- im Falle einer gestörten oder unterbrochenen Kommunikationsverbindung (81) zwischen den Schutzgeräten (13b, 13d) an beiden Enden der von dem Fehler betroffenen Leitung (11b) die Bestimmung des Fehlerortes lediglich anhand der eigenen gespeicherten Strom- und Spannungsmesswerte und der ermittelten Parameter für die Erdimpedanz und die Koppelimpedanz durchgeführt wird.

9. Verfahren nach einem der vorangehenden Ansprüche,
**dadurch gekennzeichnet, dass**

- zwischen den benachbarten Schutzgeräten (13a, 13b) an den einzelnen Phasen (A, B, C, A', B', C') der jeweils eigenen Leitung (11a, 11b) erfasste Messwerte über die Kommunikationsverbindung (15) ausgetauscht werden;

- die Schutzfunktion zur Auswahl, welche Phasen (A, B, C, A', B', C') von dem Fehler betroffen sind, eine Impedanzmessung bezüglich der Leiter-Leiter-Schleifen der jeweiligen Leitung (11a, 11b), bezüglich der Leiter-Erde-Schleifen der jeweiligen Leitung (11a, 11b) und bezüglich durch Kombination von Phasen (A, B, C, A', B', C') beider Leitungen (11a, 11b) entstehender gemischter Leiter-Leiter-Schleifen durchführt und durch Vergleich der Schleifen-Impedanzen untereinander und/oder mit einem jeweiligen Schleifen-Impedanzschwellenwert auf die jeweils fehlerbehaftete Schleife schließt.

10. Verfahren nach einem der vorangehenden Ansprüche,
**dadurch gekennzeichnet, dass**

- die Schutzfunktion zur Überprüfung, ob auf beiden Leitungen (11a, 11b) ein Erdkurzschluss vorliegt, die eigenen und die vom jeweils anderen Schutzgerät (13a, 13b) empfangenen Messwerte daraufhin untersucht, ob bezüglich einer oder mehrerer Phasen (A, B, C, A', B', C') eine Stromüberhöhung im Vergleich zu anderen Phasen (A, B, C, A', B', C') auftritt und bei einer Stromüberhöhung in einzelnen Phasen (A, B, C, A', B', C') unterschiedlicher Leitungen (11a, 11b) auf einen Erdkurzschluss auf beiden Leitungen (11a, 11b) schließt.

**11.** Schutzsystem zum Überwachen eines elektrischen Energieversorgungsnetzes mit

- einem ersten Schutzgerät (13a), das mit einer ersten Leitung (11a) des Energieversorgungsnetzes zum Erfassen von den Betriebszustand der ersten Leitung (11a) charakterisierenden Messwerten in Verbindung steht, wobei das erste Schutzgerät (13a) über eine Kommunikationsverbindung (15) mit einem benachbart angeordneten zweiten Schutzgerät (13b) verbunden ist, und wobei
- das zweite Schutzgerät (13b) mit einer parallel zu der ersten Leitung (11a) verlaufenden zweiten Leitung (11b) des Energieversorgungsnetzes zum Erfassen von den Betriebszustand der zweiten Leitung (11b) charakterisierenden Messwerten in Verbindung steht,
- die beiden Schutzgeräte (13a, 13b) jeweils eine Kommunikationseinrichtung (26) umfassen, die dazu eingerichtet ist, die von den Schutzgeräten (13a, 13b) bezüglich ihrer jeweiligen Leitung (11a, 11b) erfassten Messwerte und/oder von diesen Messwerten abgeleitete Signale an das jeweils andere Schutzgerät (13a, 13b) zu übertragen,
- jedes Schutzgerät (13a, 13b) eine Steuereinrichtung (22) aufweist, die zur Ausführung einer Schutzfunktion, insbesondere einer Distanzschutzfunktion, für die jeweilige Leitung (11a, 11b) unter Ausführung eines Haupt-Schutzalgorithmus (25) eingerichtet ist, wobei das erste Schutzgerät (13a) zur Ausführung seines Haupt-Schutzalgorithmus (25) die an der ersten Leitung (11a) erfassten Messwerte sowie die von dem zweiten Schutzgerät (13b) empfangenen Messwerte und/oder Signale heranzieht, und das zweite Schutzgerät (13b) zur Ausführung seines Haupt-Schutzalgorithmus (25) die an der zweiten Leitung (11b) erfassten Messwerte sowie die von dem ersten Schutzgerät (13a) empfangenen Messwerte und/oder Signale heranzieht,

**dadurch gekennzeichnet, dass**

- die Schutzfunktion eine Distanzschutzfunktion umfasst;
- die Steuereinrichtung (22) des jeweiligen Schutzgeräts (13a, 13b) dazu eingerichtet ist, zur Durchführung der Distanzschutzfunktion mittels des Haupt-Schutzalgorithmus (25) aus den an ihrer jeweiligen Leitung (11a, 11b) erfassten Messwerten komplexe Impedanzwerte zu berechnen und ein Fehlersignal zu erzeugen, wenn die Impedanzwerte innerhalb eines Auslösegebietes liegen;
- die Steuereinrichtungen dazu eingerichtet sind, zwischen den benachbarten Schutzgeräten (13a, 13b) an den einzelnen Phasen (A, B, C, A', B', C') der jeweils eigenen Leitung (11a, 11b) erfasste Messwerte über die Kommunikationsverbindung (15) auszutauschen;
- die Steuereinrichtungen dazu eingerichtet sind, die Schutzfunktion unter Berücksichtigung der eigenen Messwerte und der Messwerte vom jeweils anderen Schutzgerät (13a, 13b) eine Überprüfung durchzuführen, ob gleichzeitig auf beiden Leitungen (11a, 11b) ein Erdkurzschluss vorliegt, indem die Strommesswerte der einzelnen Phasen (A, B, C, A', B', C') jeweils untereinander oder mit bestimmten Schwellenwerten verglichen werden, um einzelne Phasen beider Leitungen zu erkennen, in denen vergleichsweise hohe Ströme fließen, und ein gleichzeitig auf beiden Leitungen (11a, 11b) vorliegender Erdkurzschluss erkannt wird, wenn für die erkannten Phasen zusätzlich die komplexen Impedanzwerte in dem Auslösegebiet liegen; und
- die Steuereinrichtungen dazu eingerichtet sind, bei positivem Ergebnis der Überprüfung die Schutzfunktion eine Auslösung der entsprechenden Leistungsschalter (12a, 12b) nur bezüglich der von dem Fehler tatsächlich betroffenen Phasen (A, B, C, A', B', C') der beiden Leitungen (11a, 11b) zu veranlassen.

**12.** Schutzsystem nach Anspruch 11,
**dadurch gekennzeichnet, dass**

- die Kommunikationsverbindung (15) eine Breitband-Datenverbindung ist.

**13.** Schutzsystem nach Anspruch 12,
**dadurch gekennzeichnet, dass**

- die Breitband-Datenverbindung eine Glasfaserleitung umfasst.

**14.** Schutzsystem nach einem der Ansprüche 11 bis 13,
**dadurch gekennzeichnet, dass**

- die erste und die zweite Leitung (11a, 11b) jeweils dreiphasige Leitungen eines dreiphasigen Energieversorgungsnetzes sind,
- beide Schutzgeräte (13a, 13b) jeweils eine Messwerterfassungseinrichtung (20) aufweisen, die dazu eingerichtet ist, für jede Phase gesondert die Messwerte der jeweiligen Leitung (11a, 11b) zu erfassen, und
- die Kommunikationseinrichtungen (26) der Schutzgeräte (13a, 13b) dazu eingerichtet sind, über die Kommunikationsverbindung (15) für jede Phase die entsprechenden Messwerte und/oder Signale zu übertragen.

**15.** Schutzsystem nach einem der Ansprüche 12 bis 14,
**dadurch gekennzeichnet, dass**

- beide Schutzgeräte (13a, 13b) eine Zeitstempeleinrichtung (21) aufweisen, die dazu eingerichtet ist, den an der jeweiligen Leitung (11a, 11b) erfassten Messwerten jeweils einen den Zeitpunkt ihrer Erfassung angebenden Zeitstempel zuzuordnen, und
- die Kommunikationseinrichtung (26) dazu eingerichtet ist, gemeinsam mit den über die Kommunikationsverbindung (15) übertragenen Messwerten jeweils die zugehörigen Zeitstempel zu übermitteln.

**16.** Schutzsystem nach einem der Ansprüche 12 bis 15,
**dadurch gekennzeichnet, dass**

- beide Schutzgeräte (13a, 13b) jeweils eine Kommunikations-überwachungseinrichtung (32) aufweisen, die dazu eingerichtet ist, die Funktionstüchtigkeit der Kommunikationsverbindung (15) zu überwachen und ein Ausfallsignal abzugeben, wenn die Funktionstüchtigkeit der Kommunikationsverbindung (15) nicht gewährleistet ist, und
- die Steuereinrichtung (22) der Schutzgeräte (13a, 13b) dazu eingerichtet ist, bei vorliegendem Ausfallsignal zur Ausführung der Schutzfunktion für ihre jeweilige Leitung (11a, 11b) einen von dem Haupt-Schutzalgorithmus (25) verschiedenen Ersatz-Schutzalgorithmus (31) zu verwenden, der nur die an der jeweils eigenen Leitung (11a bzw. 11b) erfassten Messwerte, nicht aber die von dem jeweils anderen Schutzgerät (13a bzw. 13b) empfangenen Messwerte und/oder Signale heranzieht.

**17.** Elektrisches Schutzgerät (13a) zur Überwachung einer ersten Leitung (11a) eines elektrischen Energieversorgungsnetzes mit

- einer Messwerterfassungseinrichtung (20), die mit der ersten Leitung (11a) des Energieversorgungsnetzes zum Erfassen von den Betriebszustand der ersten Leitung (11a) charakterisierenden Messwerten verbindbar ist, und
- einer Kommunikationseinrichtung (26), über die eine Kommunikationsverbindung (15) zwischen dem Schutzgerät (13a) und einem benachbart zu dem Schutzgerät (13a) angeordneten zweiten Schutzgerät (13b) herstellbar ist, wobei
- bei bestehender Kommunikationsverbindung (15) zwischen den Schutzgeräten (13a, 13b) Messwerte und/oder von diesen Messwerten abgeleitete Signale zwischen den Schutzgeräten (13a, 13b) übertragen werden,
- das Schutzgerät (13a) eine Steuereinrichtung (22) aufweist, die zur Ausführung einer Schutzfunktion, insbesondere einer Distanzschutzfunktion, für die erste Leitung (11a) unter Ausführung eines Haupt-Schutzalgorithmus (25) eingerichtet ist, wobei das Schutzgerät (13a) zur Ausführung seines Haupt-Schutzalgorithmus (25) die an der ersten Leitung (11a) erfassten Messwerte sowie die von dem zweiten Schutzgerät (13b) empfangenen Messwerte und/oder Signale bezüglich einer parallel zu der ersten Leitung (11a) verlaufenden zweiten Leitung (11b) heranzieht,

**dadurch gekennzeichnet, dass**

- die Schutzfunktion eine Distanzschutzfunktion umfasst;
- die Steuereinrichtung (22) des Schutzgeräts (13a) dazu eingerichtet ist, zur Durchführung der Distanzschutzfunktion mittels des Haupt-Schutzalgorithmus (25) aus den an ihrer Leitung (11a, 11b) erfassten Messwerten komplexe Impedanzwerte zu berechnen und ein Fehlersignal zu erzeugen, wenn die Impedanzwerte innerhalb eines Auslösegebietes liegen;
- die Steuereinrichtung des Schutzgerätes (13a) dazu eingerichtet ist, mit der Steuereinrichtung eines benachbarten Schutzgerätes (13b) an den einzelnen Phasen (A, B, C, A', B', C') der jeweils eigenen Leitung (11a, 11b) erfasste Messwerte über die Kommunikationsverbindung (15) auszutauschen;
- die Steuereinrichtung des Schutzgerätes (13a) dazu eingerichtet ist, unter Berücksichtigung der eigenen Messwerte und der Messwerte vom anderen Schutzgerät (13a, 13b) eine Überprüfung durchzuführen, ob gleichzeitig auf beiden Leitungen (11a, 11b) ein Erdkurzschluss vorliegt, indem die Strommesswerte der einzelnen Phasen (A, B, C, A', B', C') jeweils untereinander oder mit bestimmten Schwellenwerten verglichen werden, um einzelne Phasen beider Leitungen zu erkennen, in denen vergleichsweise hohe Ströme fließen, und ein gleichzeitig auf beiden Leitungen (11a, 11b) vorliegender Erdkurzschluss erkannt wird, wenn für die erkannten Phasen zusätzlich die komplexen Impedanzwerte in dem Auslösegebiet liegen; und

- die Steuereinrichtung des Schutzgerätes (13a) dazu eingerichtet ist, bei positivem Ergebnis der Überprüfung die Schutzfunktion eine Auslösung der entsprechenden Leistungsschalter (12a, 12b) nur bezüglich der von dem Fehler tatsächlich betroffenen Phasen (A, B, C, A', B', C') der beiden Leitungen (11a, 11b) zu veranlassen.

18. Elektrisches Schutzgerät (13a) nach Anspruch 17,
**dadurch gekennzeichnet, dass**

- das Schutzgerät (13a) eine Kommunikationsüberwachungseinrichtung (32) aufweist, die dazu eingerichtet ist, die Funktionstüchtigkeit der Kommunikationsverbindung (15) zu überwachen und ein Ausfallsignal abzugeben, wenn die Funktionstüchtigkeit der Kommunikationsverbindung (15) nicht gewährleistet ist, und
- die Steuereinrichtung (22) dazu eingerichtet ist, bei vorliegendem Ausfallsignal zur Ausführung der Schutzfunktion für ihre Leitung (11a) einen von dem Haupt-Schutzalgorithmus (25) verschiedenen Ersatz-Schutzalgorithmus (31) zu verwenden, der nur die an der ersten Leitung (11a) erfassten Messwerte, nicht aber die von dem zweiten Schutzgerät (13b) empfangenen Messwerte und/oder Signale heranzieht.

**Claims**

1. Method for monitoring a multiphase electrical power supply system, wherein

- a first protection device (13a) is connected to a first line (11a) of the power supply system for detection of measured values characterizing the operating state of the first line (11a), wherein the first protection device (13a) is connected via a communications link (15) to an adjacent second protection device (13b), and wherein
- the second protection device (13b) is connected to a second line (11b) of the power supply system, said second line running parallel to the first line (11a), for detection of measured values characterizing the operating state of the second line (11b),
- the two protection devices (13a, 13b) transmit the measured values detected thereby with respect to their respective line (11a, 11b) and/or signals derived from these measured values to the respective other protection device (13a, 13b),
- each protection device (13a, 13b) is set up to carry out a protection function, in particular a distance protection function, for its respective line (11a, 11b) whilst implementing a primary protection algorithm (25),
- the first protection device (13a) utilizes the measured values detected at the first line (11a) and the measured values and/or signals received from the second protection device (13b) to implement its primary protection algorithm (25), and
- the second protection device (13b) utilizes the measured values detected at the second line (11b) and the measured values and/or signals received from the first protection device (13a) to implement its primary protection algorithm (25), **characterized in that**
- the protection function includes a distance protection function, wherein, to carry out the distance protection function by means of the primary protection algorithm (25), the protection devices (13a, 13b) calculate complex impedance values from the measured values detected at their respective line (11a, 11b) and generate a fault signal if the impedance values lie within a trigger field;
- measured values detected at the individual phases (A, B, C, A', B', C') of the respective inherent line (11a, 11b) are exchanged between the adjacent protection devices (13a, 13b) via the communications link (15);
- the protection function carries out an inspection, under consideration of the inherent measured values and the measured values from the respective other protection device (13a, 13b), to establish whether an earth fault is present simultaneously over both lines (11a, 11b), by virtue of the current measured values of the individual phases (A, B, C, A', B', C') being compared in each case with one another or with specific threshold values in order to identify individual phases of both lines in which relatively high currents flow, and an earth fault present simultaneously over both lines (11a, 11b) is identified if, for the identified phases, the complex impedance values additionally lie in the trigger field; and
- in the case of a positive result of the examination, the protection function triggers the corresponding circuit breaker (12a, 12b) merely in respect of the phases (A, B, C, A', B', C') of the two lines (11a, 11b) actually affected by the fault.

2. Method according to Claim 1,

**characterized in that**

- the first and second line (11a, 11b) are each three-phase lines of a three-phase power supply system,
- both protection devices (13a, 13b) detect separately for each phase (A, B, C, A', B', C') the measured values of the respective line (11a, 11b), and
- the corresponding measured values and/or signals derived from these measured values are transmitted via the communications link (15) for each phase (A, B, C, A', B', C').

3. Method according to Claim 1 or 2,
   **characterized in that**

   - both protection devices (13a, 13b) have a time-stamp unit (21) with which the measured values detected at the respective line (11a, 11b) are each assigned a time stamp indicating the time at which said measured values were detected, and
   - the respective time stamp is transferred together with the measured values transmitted via the communications link (15).

4. Method according to one of the preceding claims,
   **characterized in that**

   - both protection devices (13a, 13b) have a communications monitoring unit (32), which monitors the functional efficiency of the communications link (15) and outputs a failure signal if the functional efficiency of the communications link (15) is not guaranteed, and,
   - if a failure signal is present, a replacement protection algorithm (31), which is different from the primary protection algorithm (25), is used by the protection devices (13a, 13b) to carry out the protection function for their respective line (11a, 11b) and only utilizes the measured values detected at the respective inherent line (11a or 11b), and not the measured values and/or signal is received by the respective other protection device (13a or 13b).

5. Method according to one of the preceding claims,
   **characterized in that**

   - the protection devices (13a, 13b) exchange operating status signals with one another, which at least indicate whether the line (11a, 11b) monitored by the respective protection device (13a, 13b) is fully connected or fully disconnected;
   - in the event of a single-pole fault over the inherent line (11a, 11b), the corresponding protection device (13a, 13b) stores a course of current measured values and voltage measured values and inspects the operating status signal of the adjacent protection device (13a, 13b); and
   - if the inspection reveals that the adjacent line (11a, 11b) is fully disconnected, the protection device (13a, 13b) which has identified the fault over its line (11a, 11b) receives stored current measured values and voltage measured values from a further protection device (13c, 13d) arranged at the other end of the same line (11a, 11b), said protection device likewise having stored said current measured values and voltage measured values detected at its end of the line (11a, 11b) during the fault, and calculates a fault location by means of the received currents measured values and voltage measured values and by means of the inherently stored current measured values and voltage measured values, said fault location indicating the point of the line (11a, 11b) at which the fault has occurred;
   - the protection device (13c, 13d) in question uses the calculated fault location as a basis to determine a value for an impedance to earth, said value, if the fault location were determined merely on the basis of the inherently stored current measured values and voltage measured values, determining the same fault location as with use of the current measured values and voltage measured values from both ends of the line; and
   - the calculated value for the impedance to earth is provided in the protection device (13c, 13d) as a parameter for the impedance to earth.

6. Method according to Claim 5,
   **characterized in that**

   - if the inspection reveals that the adjacent line (11a, 11b) is fully connected, the protection device (13a, 13b) which identified the fault over its line (11a, 11b) receives current measured values and voltage measured values from the further protection device (13c, 13d) which is arranged at the other end of the same line (11a, 11b) and which has stored said current measured values and voltage measured values detected at its end during the fault, and calculates a fault location by means of the received current measured values and voltage measured values and the inherently stored current measured values and voltage measured values, said fault location indicating the point of the line (11a, 11b) at which the fault has occurred;

- the protection device (13a, 13b) uses the calculated fault location and the provided parameter for impedance to earth as a basis to determine a value for a coupling impedance, said value, if the fault location were determined merely on the basis of the inherently stored current measured values and voltage measured values, determining the same fault location as with use of the current measured values and voltage measured values from both ends of the line (11a, 11b); and

- the calculated value for the coupling impedance is provided in the protection device (13a, 13b) as a parameter for the coupling impedance.

7. Method according to Claim 5 or 6,
   **characterized in that**

   - in a line (for example 11b), which is formed in part as an overhead line (91) and in part as a cable (92), the fault location is determined either with use of the current measured values and voltage measured values from the other end of the line (11b) or merely on the basis of the inherently stored current measured values and voltage measured values and the established parameters for impedance to earth and coupling impedance; and,
   - provided the fault lies over the part of the line (11b) formed as an overhead line (91), an automatic reclosing is activated, which causes the circuit breaker opened for disconnection of the fault to be closed again after a waiting period; and
   - automatic reclosing is blocked if the fault lies over the part of the line (11b) formed as a cable (92).

8. Method according to Claim 7,
   **characterized in that**

   - in the case of a functionally efficient communications link (81) between the protection devices (for example 13b, 13d) at both ends of the line (for example 11b) affected by fault, the fault location is determined on the basis of the current measured values and voltage measured values of both ends of the line (11b), and,
   - in the event of a faulty or interrupted communications link (81) between the protection devices (13b, 13d) at both ends of the line (11b) affected by the fault, the fault location is determined merely on the basis of the inherently stored current measured values and voltage measured values and the established parameters for impedance to earth and coupling impedance.

9. Method according to one of the preceding claims, **characterized in that**

   - measured values detected at the individual phases (A, B, C, A', B', C') of the respective inherent line (11a, 11b) are exchanged between the adjacent protection devices (13a, 13b) via the communications link (15);
   - the protection function carries out an impedance measurement with reference to the phase-to-phase loops of the respective line (11a, 11b), with reference to the phase-to-earth loops of the respective line (11a, 11b), and with reference to mixed phase-to-phase loops produced by combining phases (A, B, C, A', B', C') of both lines (11a, 11b), so as to select the phases (A, B, C, A', B', C') which are affected by the fault, and comes to a conclusion regarding the respective defective loop by comparing the loop impedances and/or by means of a respective loop impedance threshold value.

10. Method according to one of the preceding claims,
    **characterized in that**

    - the protection function for inspecting whether an earth fault is present over both lines (11a, 11b) examines the inherent measured values and the measured values received from the respective other protection device (13a, 13b) to establish whether there is an increase in current with regard to one or more phases (A, B, C, A', B', C') compared to other phases (A, B, C, A', B', C'), and concludes that there is an earth fault over both lines (11a, 11b) if there is an increase in current in individual phases (A, B, C, A', B', C') of different lines (11a, 11b).

11. Protection system for monitoring an electrical power supply system, said protection system comprising

- a first protection device (13a) which is connected to a first line (11a) of the power supply system for detection of measured values characterizing the operating state of the first line (11a), wherein the first protection device (13a) is connected via a communications link (15) to an adjacent second protection device (13b), and wherein
- the second protection device (13b) is connected to a second line (11b) of the power supply system, said second line running parallel to the first line (11a), for detection of measured values characterizing the operating state of the second line (11b),
- the two protection devices (13a, 13b) each comprise a communications unit (26) which is set up to transmit the measured values detected by the protection devices (13a, 13b) with respect to their respective line (11a, 11b) and/or signals derived from these measured values to the respective other protection device (13a, 13b),
- each protection device (13a, 13b) has a control unit (22) which is set up to carry out a protection function, in particular a distance protection function, for the respective line (11a, 11b) whilst implementing a primary protection algorithm (25), wherein the first protection device (13a) utilizes the measured values detected at the first line (11a) and the measured values and/or signals received from the second protection device (13b) to implement its primary protection algorithm (25), and the second protection device (13b) utilizes the measured values detected at the second line (11b) and the measured values and/or signals received from the first protection device (13a) to implement its primary protection algorithm (25), **characterized in that**
- the protection function includes a distance protection function;
- the control unit (22) of the respective protection device (13a, 13b) is set up, to carry out the distance protection function by means of the primary protection algorithm (25), to calculate complex impedance values from the measured values detected at their respective line (11a, 11b) and to generate a fault signal if the impedance values lie within a trigger field;
- the control units are set up to exchange measured values detected at the individual phases (A, B, C, A', B', C') of the respective inherent line (11a, 11b) between the adjacent protection devices (13a, 13b) via the communications link (15);
- the control units are set up to carry out an inspection, under consideration of the inherent measured values and the measured values from the respective other protection device (13a, 13b), to establish whether an earth fault is present simultaneously over both lines (11a, 11b), by virtue of the current measured values of the individual phases (A, B, C, A', B', C') being compared in each case with one another or with specific threshold values in order to identify individual phases of both lines in which relatively high currents flow, and an earth fault present simultaneously over both lines (11a, 11b) is identified if, for the identified phases, the complex impedance values additionally lie in the trigger field; and
- the control units are set up, in the case of a positive result of the examination, to trigger the corresponding circuit breaker (12a, 12b) merely in respect of the phases (A, B, C, A', B', C') of the two lines (11a, 11b) actually affected by the fault.

**12.** Protection system according to Claim 11,
**characterized in that**

- the communications link (15) is a broadband data link.

**13.** Protection system according to Claim 12,
**characterized in that**

- the broadband data link includes a fiber-optic cable.

**14.** Protection system according to one of Claims 11 to 13,
**characterized in that**

- the first and second line (11a, 11b) are each three-phase lines of a three-phase power supply system,
- both protection devices (13a, 13b) have a measured value detection unit (20), which is set up to detect separately for each phase the measured values of the respective line (11a, 11b), and
- the communications units (26) of the protection devices (13a, 13b) are set up to transmit the corresponding measured values and/or signals via the communications link (15) for each phase.

**15.** Protection system according to one of Claims 12 to 14,
**characterized in that**

- both protection devices (13a, 13b) have a time-stamp unit (21), which is set up to assign a time stamp to the measured values detected at the respective line (11a, 11b), said time stamp indicating the time at which the measured values were detected, and
- the communications unit (26) is set up to transfer the respective time stamp together with the measured values transmitted via the communications link (15).

16. Protection system according to one of Claims 12 to 15, **characterized in that**

- both protection devices (13a, 13b) also have a communications monitoring unit (32), which is set up to monitor the functional efficiency of the communications link (15) and to output a failure signal if the functional efficiency of the communications link (15) is not guaranteed, and,
- if a failure signal is present, the control unit (22) of the protection devices (13a, 13b) is set up to use a replacement protection algorithm (31), which is different from the primary protection algorithm (25), to carry out the protection function for their respective line (11a, 11b), said replacement protection algorithm only utilizing the measured values detected at the respective inherent line (11a, 11b), and not the measured values and/or signals received by the respective other protection device (13a, 13b).

17. Electrical protection device (13a) for monitoring a first line (11a) of an electrical power supply system, said protection device comprising

- a measured value detection unit (20), which can be connected to the first line (11a) of the power supply system for detection of measured values characterizing the operating state of the first line (11a), and
- a communications unit (26), via which a communications link (15) between the protection device (13a) and a second protection device (13b) adjacent to said protection device (13a) can be produced, wherein
- if there is an existing communications link (15) between the protection devices (13a, 13b), measured values and/or signals derived from these measured values are transmitted between the protection devices (13a, 13b), and
- the protection device (13a) has a control unit (22), which is set up to implement a protection function, in particular a distance protection function, for the first line (11a) whilst implementing a primary protection algorithm (25), wherein, to implement its primary protection algorithm (25), the protection device (13a) utilizes the measured values detected at the first line (11a) and the measured values and/or signals received from the second protection device (13b) with respect to a second line (11b) extending parallel to the first line (11a), **characterized in that**
- the protection function includes a distance protection function;
- the control unit (22) of the protection device (13a) is set up, to carry out the distance protection function by means of the primary protection algorithm (25), to calculate complex impedance values from the measured values detected at their line (11a, 11b) and to generate a fault signal if the impedance values lie within a trigger field;
- the control unit of the protection device (13a) is set up to exchange measured values detected at the individual phases (A, B, C, A', B', C') of the respective inherent line (11a, 11b) with the control unit of an adjacent protection device (13b) via the communications link (15);
- the control unit of the protection device (13a) is set up to carry out an inspection, under consideration of the inherent measured values and the measured values from the other protection device (13a, 13b), to establish whether an earth fault is present simultaneously over both lines (11a, 11b), by virtue of the current measured values of the individual phases (A, B, C, A', B', C') being compared in each case with one another or with specific threshold values in order to identify individual phases of both lines in which relatively high currents flow, and an earth fault present simultaneously over both lines (11a, 11b) is identified if, for the identified phases, the complex impedance values additionally lie in the trigger field; and
- the control unit of the protection device (13a) is set up, in the case of a positive result of the examination, to trigger the corresponding circuit breaker (12a, 12b) merely in respect of the phases (A, B, C, A', B', C') of the two lines (11a, 11b) actually affected by the fault.

18. Electrical protection device (13a) according to Claim 17, **characterized in that**

- the protection device (13a) has a communications monitoring unit (32), which is set up to monitor the functional efficiency of the communications link (15) and to output a failure signal if the functional efficiency of the communications link (15) is not guaranteed, and,
- if a failure signal is present, the control unit (22) is set up to use a replacement protection algorithm (31), which is different from the primary protection algorithm (25), to carry out the protection function for its line (11a), said replacement protection algorithm only utilizing the measured values detected at the first line (11a), and not the measured values and/or signals received by the second protection device (13b) .

**Revendications**

1.  Procédé de contrôle d'un réseau d'alimentation en énergie électrique polyphasé, dans lequel

    - un premier appareil (13a) de protection est en liaison avec une première ligne (11a) du réseau d'alimentation en énergie électrique pour relever des valeurs de mesure caractérisant l'état de fonctionnement de la première ligne (11a), le premier appareil (13a) de protection étant relié à un deuxième appareil (13b) de protection disposé au voisinage, par l'intermédiaire d'une liaison (15) de communication, et dans lequel
    - le deuxième appareil (13b) de protection est en liaison avec une deuxième ligne (11b) du réseau d'alimentation en énergie électrique s'étendant parallèlement à la première ligne (11a) pour relever des valeurs de mesure caractérisant l'état de fonctionnement de la deuxième ligne (11b),
    - les deux appareils (13a, 13b) de protection transmettent à respectivement l'autre appareil (13b, 13a) de protection les valeurs de mesure qu'ils ont relevées en ce qui concerne leur propre ligne (11a, 11b) et/ou des signaux déduits de ces valeurs de mesure,
    - chaque appareil (13a, 13b) de protection est conçu pour l'exécution d'une fonction de protection, notamment d'une fonction de protection à distance, pour sa propre ligne (11a, 11b) en exécutant un algorithme (25) de protection principal,
    - le premier appareil (13a) de protection tire parti, pour l'exécution de son algorithme (25) de protection principal, des valeurs de mesure relevées sur la première ligne (11a), ainsi que des valeurs de mesure et/ou des signaux reçus du deuxième appareil (13b) de protection et
    - le deuxième appareil (13b) de protection tire parti, pour l'exécution de son algorithme (25) de protection principal, des valeurs de mesure relevées sur la deuxième ligne (11b), ainsi que des valeurs de mesure et/ou des signaux reçus du premier appareil (13a) de protection, **caractérisé en ce que**
    - la fonction de protection comprend une fonction de protection à distance, les appareils (13a, 13b) de protection calculant, pour l'exécution de la fonction de protection à distance, des valeurs d'impédance complexes au moyen de l'algorithme (25) de protection principal à partir des valeurs de mesure relevées sur leur propre ligne (11a, 11b) et produisant un signal de défaut, si les valeurs d'impédance sont à l'intérieur d'un domaine de déclenchement,
    - entre les appareils (13a, 13b voisins, on échange par la liaison (15) de communication des valeurs de mesure relevées sur les diverses phases (A, B, C, A', B', C'),
    - la fonction de protection effectue, en tenant compte des valeurs de mesure propres et des valeurs de mesure de l'autre appareil (13a, 13b) respectif, un contrôle sur le point de savoir s'il y a un court-circuit à la terre en même temps sur les deux lignes (11a, 11b), en comparant les valeurs de mesure du courant des diverses phases (A, B, C, A', B', C'), respectivement entre elles ou à des valeurs de seuil déterminées, pour détecter des phases individuelles des deux lignes, dans lesquelles passent des courants relativement intenses, et un court-circuit à la terre présent en même temps sur les deux lignes (11a, 11b) est détecté si, pour les phases détectées, supplémentairement les valeur d'impédance complexes sont dans le domaine de déclenchement et
    - si le résultat du contrôle est positif, la fonction de protection provoque un déclenchement des disjoncteurs (12a, 12b) correspondants seulement en ce qui concerne les phases (A, B, C, A', B', C'), réellement concernées par le défaut, des deux lignes (11a, 11b).

2.  Procédé suivant la revendication 1,
    **caractérisé en ce que**

    - la première et la deuxième lignes (11a, 11b) sont chacune des lignes triphasées d'un réseau d'alimentation en énergie électrique triphasé,
    - les deux appareils (13a, 13b) de protection relèvent chacun pour chaque phase (A, B, C, A', B', C') séparément les valeurs de mesure de leur propre ligne (11a, 11b) et
    - les valeurs de mesure correspondantes et/ou des signaux déduits de ces valeurs de mesure sont transmis par la liaison (15) de communication pour chaque phase (A, B, C, A', B', C').

3.  Procédé suivant la revendication 1 ou 2,
    **caractérisé en ce que**

- les deux appareils (13a, 13b) de protection ont un dispositif (21) d'horodatage, par lequel il est affecté un horodatage indiquant l'instant de leur relevé aux valeurs de mesure relevées sur leur propre ligne (11a, 11b) et
- les horodatages associés sont transmis conjointement avec les valeurs de mesure transmises par la liaison (15) de communication.

**4.** Procédé suivant l'une des revendications précédentes, **caractérisé en ce que**

- les deux appareils (13a, 13b) de protection ont chacun un dispositif (32) de communication, qui contrôle l'aptitude à bien fonctionner de la liaison (15) de communication et qui émet un signal de panne si l'aptitude à bien fonctionner de la liaison (15) de communication n'est pas assurée et
- il est utilisé par les appareils (13a, 13b) de protection, en présence d'un signal de panne, pour l'exécution de la fonction de protection de leur propre ligne (11a, 11b), un algorithme (31) de protection de remplacement, différent de l'algorithme (25) de protection principal, qui tire parti seulement des valeurs de mesure relevées sur la propre ligne (11a et 11b), mais non des valeurs de mesure et/ou des signaux reçus de l'autre appareil (13a et 13b) de protection.

**5.** Procédé suivant l'une des revendications précédentes, **caractérisé en ce que**

- les appareils (13a, 13b) de protection échangent entre eux des signaux d'état de fonctionnement, qui indiquent au moins si la ligne (11a, 11b), contrôlée par l'appareil (13a, 13b) de protection respectif, est branchée complètement ou débranchée complètement;
- pendant un défaut monopolaire sur la ligne (11a, 11b) propre, l'appareil (13a, 13b) de protection correspondant mémorise une courbe de valeurs de mesure de courant et de tension et contrôle le signal d'état de fonctionnement de l'appareil (13a, 13b) de protection voisin et
- dès que le contrôle indique que la ligne (11a, 11b) voisine est débranchée complètement, l'appareil (13a, 13b) de protection, qui a détecté le défaut sur sa ligne (11a, 11b), reçoit, d'un autre appareil (13c, 13d) de protection monté à l'autre extrémité de la même ligne (11a, 11b) et ayant mémorisé des valeurs de mesure du courant et de la tension relevées pendant les défaut à son extrémité de la même ligne (11a, 11b), ces valeurs de mesures de tension et de courant mémorisées et calcule, avec les valeurs de mesure de tension et de courant reçues et celles mémorisées en propre, un emplacement de défaut, qui indique en quel point de la ligne le défaut s'est produit;
- l'appareil (13c, 13d) de protection concerné détermine, à l'aide de l'emplacement de défaut calculé, une valeur de l'impédance de terre par laquelle, lors d'une détermination de l'emplacement de défaut seulement à l'aide des valeurs de mesure de courant et de tension propres mémorisées, le même emplacement de défaut aurait été déterminé qu'en utilisant les valeurs de mesure de courant et de tension des deux extrémités de la ligne et
- la valeur calculée de l'impédance de terre est mise à disposition dans l'appareil (13c, 13d) de protection, comme paramètre de l'impédance de terre.

**6.** Procédé suivant la revendication 5, **caractérisé en ce que**

- dans la mesure où le contrôle indique que la ligne (11a, 1b) voisine est branchée complètement, l'appareil (13a, 3b) de protection, qui a détecté le défaut sur sa ligne (11a, 1b), reçoit, de l'autre appareil (13c, 13d) de protection, monté à l'autre extrémité de la même ligne (11a, 11b) et ayant mémorisé des valeurs de mesure du courant et de la tension détectée à son extrémité pendant le défaut, ces valeurs de mesure de courant et de tension mémorisées et calcule, avec les valeurs de mesure de courant et de tension reçues et les valeurs de mesure de courant et de tension propres mémorisées, un emplacement de défaut, qui indique en quel point de la ligne (11a, 11b) le défaut s'est produit;
- l'appareil (13a, 13b) de protection détermine, à l'aide de l'emplacement de défaut calculé et du paramètre mis à disposition de l'impédance de terre, une valeur d'une impédance de couplage, par laquelle, lors d'une détermination de l'emplacement du défaut seulement à l'aide des valeurs de mesure de courant et de tension propres mémorisées, un emplacement de défaut aurait été déterminé, comme en utilisant des valeurs de mesure de courant et de tension des deux extrémités de la ligne (11a, 11b) et
- la valeur calculée de l'impédance de couplage, dans l'appareil (13a, 13b) de protection, est mise à disposition, comme paramètre de l'impédance de couplage.

**7.** Procédé suivant la revendication 5 ou 6,
**caractérisé en ce que**,

- pour une ligne (par exemple 11b) qui est réalisée en partie en ligne (91) aérienne et en partie en câble (92), on effectue une détermination de l'emplacement du défaut en utilisant les valeurs de mesure de courant et de tension de l'autre extrémité de la ligne (11b) ou seulement à l'aide de ses propres valeurs de mesure de courant et de tension mémorisées et des paramètres déterminés pour l'impédance de terre et l'impédance de couplage et,
- dans la mesure où le défaut se trouve sur la partie de la ligne (11b) réalisée en ligne (91) aérienne, on active un rebranchement automatique, qui fait que le disjoncteur ouvert, pour mettre fin au défaut, est refermé après l'écoulement d'un temps d'attente et,
- dans la mesure où le défaut se trouve sur la partie de la ligne (11b) réalisée en câble (92), le rebranchement automatique est bloqué.

**8.** Procédé suivant la revendication 7,
**caractérisé en ce que**,

- dans le cas d'une liaison (81) de communication apte à fonctionner entre les appareils (par exemple 13b, 13d) de protection aux deux extrémités de la ligne (par exemple 11b) concernée par le défaut, la détermination de l'emplacement du défaut est effectuée à l'aide des valeurs de mesure de courant et de tension des deux extrémités de la ligne (11b) et,
- dans le cas d'une liaison (81) de communication perturbée ou interrompue entre les appareils (13b, 13d) de protection aux deux extrémités de la ligne (11b) concernée par le défaut, la détermination de l'emplacement du défaut s'effectue seulement à l'aide de ses propres valeurs de mesure de courant et de tension mémorisées et des paramètres déterminés pour l'impédance de terre et l'impédance de couplage.

**9.** Procédé suivant l'une des revendications précédentes,
**caractérisé en ce que**

- il est échangé par la liaison (15) de communication entre les appareils (13a, 13b) de protection voisins des valeurs de mesure relevées sur les diverses phases (A, B, C, A', B', C') de leur propre ligne (11a, 11b),
- la fonction de protection effectue, pour le choix des phases (A, B, C, A', B', C') qui sont concernées par le défaut, une mesure d'impédance se rapportant à la boucle conducteur-conducteur de la ligne (11a, 11b) respective, se rapportant à la boucle conducteur-terre de la ligne (11a, 11b) respective et se rapportant à une boucle conducteur-conducteur mixte créée par une combinaison de phases (A, B, C, A', B', C') des deux lignes (11a, 11b) et on décide, par une combinaison des impédances de boucle entre elles et/ou avec une valeur de seuil d'impédance de boucle, de la boucle souffrant du défaut.

**10.** Procédé suivant l'une des revendications précédentes,
**caractérisé en ce que**

- la fonction de protection étudie, pour contrôler s'il y a un court-circuit de terre sur les deux lignes (11a, 11b), ses propres valeurs de mesure et les valeurs de mesure reçues de l'autre appareil (13a, 13b) de protection pour savoir s'il est apparu, en ce qui concerne l'une ou plusieurs des phases (A, B, C, A', B', C'), une surintensité par rapport aux phases (A, B, C, A', B', C') et, s'il y a une surintensité dans diverses phases (A, B, C, A', B', C') de lignes (11a, 11b) différentes, conclut à un court-circuit de terre sur les deux lignes (11a, 11b).

**11.** Système de protection pour contrôler un réseau d'alimentation en énergie électrique, comprenant

- un premier appareil (13a) de protection, qui est en liaison avec une première ligne (11a) du réseau d'alimentation en énergie, pour relever des valeurs de mesure caractérisant l'état de fonctionnement de la première ligne (11a), le premier appareil (13a) de protection étant relié par une liaison (15) de communication avec un deuxième appareil (13b) de protection voisin et dans lequel
- le deuxième appareil (13b) est en liaison avec une deuxième ligne (11b), s'étendant parallèlement à la première ligne (11a), du réseau d'alimentation en énergie, pour relever des valeurs de mesure caractérisant l'état de fonctionnement de la deuxième ligne (11b),
- les deux appareils (13a, 13b) de protection comprennent chacun un dispositif (26) de communication, qui est conçu pour transmettre à l'autre appareil (13a, 13b) de protection les valeurs de mesure relevées par les appareils (13a, 13b) de protection en ce qui concerne leur ligne (11a, 11b) respective et/ou des signaux déduits de ces valeurs de mesure,
- chaque appareil (13a, 13b) de protection a un dispositif (22) de commande, qui est conçu pour réaliser une fonction de protection, notamment une fonction de protection à distance, de la ligne (11a, 11b) respective, en exécutant un algorithme (25) de protection principal, le premier appareil (13a) de protection tirant parti, pour l'exécution de son algorithme (25) de protection principal, des valeurs de mesure relevées sur la première ligne (11a) ainsi que des valeurs de mesure et/ou des signaux reçus du deuxième appareil (13b) de protection et le deuxième appareil de protection tirant parti, pour l'exécution de son algorithme (25) de protection principal, des valeurs de mesure relevées sur la deuxième ligne (11b) ainsi que des valeurs de mesure et/ou des signaux reçus du premier appareil (13a) de protection,

**caractérisé en ce que**

- la fonction de protection comprend une fonction de protection à distance;
- le dispositif (22) de commande de l'appareil (13a, 13b) de protection respectif est conçu pour calculer, en vue d'effectuer la fonction de protection de distance au moyen de l'algorithme (25) de protection principal, à partir des valeurs de mesure relevées sur sa ligne (11a, 11b) propre, des valeurs d'impédance complexes et pour produire un signal de défaut si les valeurs d'impédance se trouvent dans un domaine de déclenchement;
- les dispositifs de commande sont conçus pour échanger, entre les appareils (13a, 13b) de protection voisins, par l'intermédiaire de la liaison (15) de communication, des valeurs de mesure relevées sur les diverses phases (A, B, C, A', B', C') de leur propre ligne (11a, 11b);
- les dispositifs de commande sont conçus pour effectuer, en tenant compte des valeurs de mesure propres et des valeurs de mesure de respectivement l'autre appareil (13a, 13b) de protection, un contrôle sur le point de savoir s'il y a, en même temps sur les deux lignes (11a, 11b) un court-circuit à la terre, en comparant les valeurs de mesure de courant des diverses phases (A, B, C, A', B', C') respectivement entre elles ou à des valeurs de seuil déterminées, afin de détecter des phases individuelles des deux lignes dans lesquelles il passe des courants relativement intenses, et un court-circuit à la terre, présent en même temps sur les deux lignes (11a, 11b), si, pour les phases détectées, supplémentairement les valeurs d'impédance complexes sont dans le domaine de déclenchement et
- les dispositifs de commande sont conçus pour que, si le résultat du contrôle est positif, la fonction de protection provoque un déclenchement du disjoncteur (12a, 12b) correspondant seulement en ce qui concerne les phases (A, B, C, A', B', C') réellement concernées par le défaut des deux lignes (11a, 11b).

12. Système de protection suivant la revendication 11,
**caractérisé en ce que**

- la liaison (15) de communication est une liaison de données à large bande.

13. Système de protection suivant la revendication 12,
**caractérisé en ce que**

- la liaison de données à large bande comprend une liaison par fibre optique.

14. Système de protection suivant l'une des revendications 11 à 19,
**caractérisé en ce que**
la première et la deuxième lignes (11a, 11b) sont respectivement des lignes triphasées d'un réseau d'alimentation en énergie triphasé,

- les deux appareils (13a, 13b) de protection ont respectivement un dispositif (20) de relevé de valeurs de mesure, qui est conçu pour relever, pour chaque phase séparément, les valeurs de mesure de la ligne (11a, 11b) respective et
- les dispositifs (26) de communication des appareils (13a, 13b) de protection sont conçus pour transmettre par la liaison (15) de communication, pour chaque phase, les valeurs de mesure et/ou les signaux correspondants.

15. Système de protection suivant l'une des revendications 12 à 14,
**caractérisé en ce que**

- les deux appareils (13a, 13b) de protection ont un dispositif (21) d'horodatage, qui est conçu pour affecter aux valeurs de mesure relevées sur la ligne (11a, 11b) respective respectivement un horodatage indiquant l'instant de leur relevé et

- le dispositif (26) de communication est conçu pour transmettre les horodatages associés conjointement aux valeurs de mesure transmises par la liaison (15) de communication.

16. Système de protection suivant l'une des revendications 12 à 15, **caractérisé en ce que**

- les deux appareils (13a, 13b) de protection ont respectivement un dispositif (32) de contrôle de communication, qui est conçu pour contrôler l'aptitude à fonctionner de la liaison (15) de communication et pour indiquer un signal de panne si l'aptitude à fonctionner de la liaison (15) de communication n'est pas assurée et
- le dispositif (22) de commande des appareils (13a, 13b) de protection est conçu pour, en présence d'un signal de panne, utiliser, pour l'exécution de la fonction de protection de sa propre ligne (11a, 11b), un algorithme (31) de protection de remplacement, différent de l'algorithme (25) de protection principal, qui tire parti seulement des valeurs de mesure relevées sur sa propre ligne (11a et 11b), mais non des valeurs de mesure et/ou des signaux reçus de l'autre appareil (13a et 13b) de protection.

17. Appareil (13a) de protection électrique pour contrôler une première ligne (11a) d'un réseau d'alimentation en énergie électrique comprenant

- un dispositif (20) de relevé de valeurs de mesure, qui peut être relié à la première ligne (11a) du réseau d'alimentation en énergie, pour relever des valeurs de mesure caractérisant l'état de fonctionnement de la première ligne (11a) et
- un dispositif (26) de communication, par lequel une liaison (15) de communication entre l'appareil (13a) de protection et un deuxième appareil (13b) de protection voisin du premier appareil (13a) de protection peut être ménagée, dans lequel
- lorsque la liaison (15) de communication existe entre les appareils (13a, 13b) de protection, les valeurs de mesure et/ou les signaux déduits de ces valeurs de mesure sont transmis entre les appareils (13a, 13b) de protection,
- l'appareil (13a) de protection a un dispositif (22) de commande, qui est conçu pour l'exécution d'une fonction de protection, notamment d'une fonction de protection à distance, de la première ligne (11a) en exécutant un algorithme (25) de protection principal, l'appareil (13a) de protection tirant parti, pour l'exécution de son algorithme (25) de protection principal, des valeurs de mesure relevées sur la première ligne (11a) ainsi que des valeurs de mesure et/ou des signaux reçus du deuxième appareil (13b) de protection en ce qui concerne une deuxième ligne (11b) s'étendant parallèlement à la première ligne (11a),

**caractérisé en ce que**

- la fonction de protection comprend une fonction de protection à distance;
- le dispositif (22) de commande de l'appareil (13a) de protection est conçu pour calculer, afin d'effectuer la fonction de protection à distance, au moyen de l'algorithme (25) de protection principal, des valeurs d'impédance complexes à partir des valeurs de mesure relevées sur sa ligne (11a, 11b) et pour produire un signal de défaut, si les valeurs d'impédance se trouvent dans un domaine de déclenchement;
- le dispositif de commande de l'appareil (13a) de protection est conçu pour échanger, par l'intermédiaire de la liaison (15) de communication, avec le dispositif de commande d'un appareil (13b) de protection voisin, des valeurs de mesure relevées sur les diverses phases (A, B, C, A', B', C') de sa propre ligne (11a, 11b);
- le dispositif de commande de l'appareil (13a) de protection est conçu pour effectuer, en tenant compte des valeurs de mesure propres et des valeurs de mesure de l'autre appareil (13a, 13b) de protection, un contrôle sur le point de savoir s'il y a, en même temps sur les deux lignes (11a, 11b), un court-circuit à la terre, en comparant les valeurs de mesure des diverses phases (A, B, C, A', B', C') entre elles ou à des valeurs de seuil déterminées, afin de détecter des phases individuelles des deux lignes, dans lesquelles passent des courants relativement intenses, et de détecter un court-circuit à la terre présent en même temps sur les deux lignes (11a, 11b) si, pour les phases détectées, les valeurs d'impédance complexes se trouvent supplémentairement dans le domaine de déclenchement et
- le dispositif de commande de l'appareil (13a) de protection est conçu pour, lorsque le résultat du contrôle est positif, faire que la fonction de protection provoque un déclenchement des disjoncteurs (12a, 12b) correspondants seulement en ce qui concerne les phases (A, B, C, A', B', C') réellement concernées par le défaut des deux lignes (11a, 11b).

**18.** Appareil (13a) de protection électrique suivant la revendication 17,
**caractérisé en ce que**

- l'appareil (13a) de protection a un dispositif (32) de contrôle de communication, qui est conçu pour contrôler l'aptitude à fonctionner de la liaison (15) de communication et pour émettre un signal de panne, si l'aptitude à fonctionner de la liaison (15) de communication n'est pas assurée et
- le dispositif (22) de commande est conçu pour, s'il y a un signal de panne, afin d'effectuer la fonction de protection pour sa ligne (11a), utiliser un algorithme (31) de protection de remplacement, différent de l'algorithme (25) de protection principal, qui ne tire parti que des valeurs de mesure relevées sur la première ligne (11a), mais non des valeurs de mesure et/ou des signaux reçus du deuxième appareil (13b) de protection.

FIG 1

## FIG 2

## FIG 3

## FIG 4

FIG 5

FIG 6

FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0031849 A
- WO 2009012800 A1
- WO 2008134998 A1
- DE 4441334 C1